# FASCICULE DE BREVET EUROPEEN

(11) **EP 4 189 755 B1**
(45) Date de publication et mention de la délivrance du brevet: **14.10.2026**
(21) Numéro de dépôt: 21752095.6
(22) Date de dépôt: 22.07.2021
(51) Int. Cl.: H10K 71/16, H10K 10/82, C03C 17/34

(54) **COUCHE TAMPON POUR LA CROISSANCE CRISTALLINE D'OXYDES METALLIQUES DE TYPE PÉROVSKITE NOTAMMENT SUR SUBSTRATS AMORPHES**
PUFFERSCHICHT FÜR DAS KRISTALLWACHSTUM VON METALLOXIDEN VOM PEROWSKIT-TYP, INSBESONDERE AUF AMORPHEN SUBSTRATEN
BUFFER LAYER FOR THE CRYSTAL GROWTH OF PEROVSKITE-TYPE METAL OXIDES, ESPECIALLY ON AMORPHOUS SUBSTRATES

(30) Priorité: 28.07.2020 FR 2007968
(43) Date de publication de la demande: 07.06.2023
(73) Titulaire: Centre National de la Recherche Scientifique, 75016 Paris (FR); Ecole Nationale Supérieure d'Ingénieurs de Caen, 14000 Caen (FR); Université de Caen Normandie, 14000 Caen (FR)
(72) Inventeur: BOILEAU, Alexis, 88200 REMIREMONT (FR); CIBERT, Christophe, 14200 HÉROUVILLE SAINT-CLAIR (FR); DAVID, Adrian, 14860 RANVILLE (FR); FOUCHET, Arnaud, 14440 DOUVRES-LA-DÉLIVRANDE (FR); GOURBILLEAU, Fabrice, 14470 COURSEULLES-SUR-MER (FR); LABBÉ, Christophe, 14280 AUTHIE (FR); LÜDERS, Ulrike, 14880 HERMANVILLE-SUR-MER (FR); POULLAIN, Gilles, 14480 BANVILLE (FR)
(74) Mandataire: Santarelli
(86) Numéro de dépôt international: PCT/FR2021/051371
(87) Numéro de publication internationale: WO 2022/023651

(56) Documents cités:
- CN-A- 101 826 550
- US-A1- 2010 102 450
- C.H. JUNG ET AL: "Fabrication of KTaNbOfilm by pulsed laser deposition on glass substrate with various buffer layers", OPTICAL MATERIALS ELSEVIER SCIENCE PUBLISHERS B.V. AMSTERDAM., NL, vol. 34, no. 1, 18 August 2011 (2011-08-18), pages 269 - 273, XP028318477, ISSN: 0925-3467, [retrieved on 20110825], DOI: 10.1016/J.OPTMAT.2011.08.023
- LUO W ET AL: "Improved crystalline properties of laser molecular beam epitaxy grown SrTiO3 by rutile TiO2 layer on hexagonal GaN", JOURNAL OF APPLIED PHYSICS, AMERICAN INSTITUTE OF PHYSICS, US, vol. 106, no. 10, 24 November 2009 (2009-11-24), pages 104120 - 104120, XP012127149, ISSN: 0021-8979, DOI: 10.1063/1.3257259
- RIZA MUHAMMAD ARIF ET AL: "Prospects and challenges of perovskite type transparent conductive oxides in photovoltaic applications. Part II - Synthesis and deposition", SOLAR ENERGY, vol. 139, 1 December 2016 (2016-12-01), pages 309 - 317, XP029809461, ISSN: 0038-092X, DOI: 10.1016/J.SOLENER.2016.08.045
- LISONI J G ET AL: "The growth of MgO buffer layers on sapphire for the epitaxy of BaTiO"3 optical thin films", THIN SOLID FILMS, ELSEVIER, AMSTERDAM, NL, vol. 389, no. 1-2, 15 June 2001 (2001-06-15), pages 219 - 226, XP004242332, ISSN: 0040-6090, DOI: 10.1016/S0040-6090(01)00887-2
- BECKERS L ET AL: "Structural and optical characterization of epitaxial waveguiding BaTiO3 thin films on MgO", JOURNAL OF APPLIED PHYSICS, AMERICAN INSTITUTE OF PHYSICS, US, vol. 83, no. 6, 15 March 1998 (1998-03-15), pages 3305 - 3310, XP012044869, ISSN: 0021-8979, DOI: 10.1063/1.367099
- SCHUBERT M. ET AL: "Electro-optical properties of ZnO-BaTiO3-ZnO heterostructures grown by pulsed laser deposition", ANNALEN DER PHYSIK., vol. 13, no. 12, 29 January 2004 (2004-01-29), DE, pages 61 - 62, XP055788673, ISSN: 0003-3804, DOI: 10.1002/andp.200310047
- XU RUIXING ET AL: "Perovskite Transparent Conducting Oxide for the Design of a Transparent, Flexible, and Self-Powered Perovskite Photodetector", ACS APPLIED MATERIALS & INTERFACES, vol. 12, no. 14, 20 March 2020 (2020-03-20), US, pages 16462 - 16468, XP055788674, ISSN: 1944-8244, DOI: 10.1021/acsami.0c01298
- MURALT P ET AL: "Texture control of PbTiO3 and Pb(Zr,Ti)O3 thin films with TiO2 seeding", JOURNAL OF APPLIED PHYSICS, AMERICAN INSTITUTE OF PHYSICS, US, vol. 83, no. 7, 1 April 1998 (1998-04-01), pages 3835 - 3841, XP012044957, ISSN: 0021-8979, DOI: 10.1063/1.366614
- LIU S-J ET AL: "GROWTH AND TRANSPORT PROPERTIES OF (110)-ORIENTED LA2/3SR1/3MNO3 THIN FILMS ON TIO2-BUFFERED SI (001) SUBSTRATES", JAPANESE JOURNAL OF APPLIED PHYSICS, JAPAN SOCIETY OF APPLIED PHYSICS, JP, vol. 42, no. 3B, PART 02, 15 March 2003 (2003-03-15), pages L287 - L290, XP001164591, ISSN: 0021-4922, DOI: 10.1143/JJAP.42.L287

## Description

### Domaine Technique de l'invention

La présente invention se rapporte aux oxydes métalliques ayant une structure cristalline de type pérovskite, et un procédé permettant leur croissance cristalline sur un substrat même inadapté tel qu'un substrat amorphe.

### Etat de la technique

Les oxydes conducteurs transparent (TCO) constituent une classe importante de matériaux avec une large gamme d'applications technologiques tels que les écrans plats et tactiles, les diodes électroluminescentes, les cellules photovoltaïques, les cellules électrochromes ou encore les antennes transparentes. Le matériau standard couramment employé est l'oxyde d'indium dopé à l'étain (In₂O₃ - SnO₂, ITO) qui possède d'excellentes propriétés fonctionnelles avec une transparence dans le visible de l'ordre de 80 % et une résistivité électrique typiquement en dessous de 100 µΩcm. De plus, la forme amorphe de l'ITO est conductrice ce qui permet de l'intégrer facilement dans des dispositifs complexes sans être limité par la compatibilité structurale et la nécessité de le déposer à température élevée. Par conséquent, l'ITO est le principal TCO employé dans les dispositifs industriels en raison de ses excellentes propriétés et la souplesse de son intégration.

Cependant, l'utilisation d'indium est le principal inconvénient de l'ITO. Cet élément, loin d'être une ressource abondante, est sujet à d'importantes variations de prix et peut constituer une difficulté d'approvisionnement dans les dispositifs de plus en plus nombreux à faire appel aux TCO. Par conséquent, la recherche de nouveaux TCO dépourvus d'indium est un domaine très actif depuis maintenant plusieurs décennies. L'un des candidats les plus en vue est le ZnO dopé mais malgré les efforts fournis, ses propriétés n'atteignent pas celles de l'ITO. En particulier, la résistivité du ZnO dopé est l'une des limitations principales qui empêche la substitution de l'ITO dans les applications actuelles.

En 2016, de nouveaux TCO basés sur des pérovskites de vanadates fortement corrélées ont été identifiés **(Ref. 1).** Plus précisément, ces matériaux qui incluent SrVO₃ (SVO) et CaVO₃ (CVO), constituent des systèmes métalliques possédant de fortes corrélations électroniques qui conduisent à une augmentation de la masse effective et de ce fait, au décalage de la fréquence plasma dans le proche infrarouge en dehors du domaine visible. Avec une densité de porteurs de l'ordre de 10²² cm⁻³, bien supérieure à celle de l'ITO (jusqu'à 10²¹ cm⁻³), SVO et CVO ont une très faible résistivité bien que la mobilité des porteurs de charge soit inférieure de plusieurs ordres de grandeur à celle des TCO semiconducteurs. A la fois la résistivité et la transparence optique des films minces épitaxiés se sont avérées comparables à celles de l'ITO positionnant ainsi ces TCO émergents exempts d'indium comme une alternative sérieuse à l'ITO.

La publication de Luo et al., Journal of Applied Physics, 2009, 106(10): 104120 décrit un système multicouche comprenant un film de titanate de strontium et une couche d'oxyde de titane superposés sur un substrat en nitrure de gallium hexagonal obtenu à partir de saphir. La publication de Lisoni et al., Thin Solid Films, 2001, 389(1-2): 219-226 décrit un système multicouche comprenant une couche de titanate de baryum et une couche d'oxyde de magnésium superposées sur un substrat en cristaux de saphir. La publication de Ruixing et al., ACS Applied Materials & Interfaces, 2020, 12(14): 16462-16468 décrit un système multicouche comprenant une couche de titanate de vanadium et une couche de titanate de strontium superposées sur un substrat en mica sous forme de fluorphlogopite. La publication de Jung et al, Optical Materials, 2011, 34(1): 269-273 décrit une structure multicouche comprenant un film de KTa_{0,65}Nb_{0,35}O₃ et une couche tampon d'oxyde métallique sur un substrat en verre.

Toutefois, le potentiel technologique des TCO de vanadates semble être limité par leur structure cristalline. En effet, il a été montré que SVO doit impérativement être cristallisé pour posséder un comportement conducteur **(Ref. 4).** De plus, la structure pérovskite n'est pas la plus stable du système Sr-V-O et ne présente les propriétés fonctionnelles recherchées que si elle est stabilisée sur un substrat adapté **(Refs. 6, 19).** La croissance directe sur silicium a été reportée mais reste très difficile à reproduire **(Refs. 20, 21).** La croissance sur verre qui est l'un des substrats les plus pertinents pour les TCO, n'a jamais été rapportée dans la littérature. En fait, de notre expérience, il est impossible d'induire la structure pérovskite de SVO en raison du caractère amorphe du verre. Par conséquent, l'utilisation des TCO de vanadates dans des dispositifs réels (utilisant des substrats transparents) est fortement compromise, reléguant ces nouveaux TCO hors du champ des applications possibles en dépit de leurs propriétés remarquables.

Il existe donc un réel besoin de développer un moyen permettant la cristallisation des TCO de vanadates sur des substrats inadaptés comme le verre, préservant à la fois les propriétés de résistivité des TCO de vanadates et la transparence optique de l'ensemble. Ce besoin s'étend plus largement aux oxydes métalliques cristallins de type pérovskite.

### BREVE DESCRIPTION DES FIGURES

[Fig. 1] représente : (a) Diffractogrammes de rayons X de films minces amorphes de SrVO₃ de 80 nm d'épaisseur déposés directement sur substrat de verre à 400 et 700°C. (b) Diffractogrammes de rayons X des couches de SrVO₃/TiO₂/verre de 100 nm d'épaisseur déposées entre 450 et 600°C.
[Fig. 2] représente: Résistivité à 300 K en fonction de la température de dépôt des films polycristallins de SrVO₃ déposés sur couche tampon de TiO₂ avec une épaisseur de 100 nm (cercles gris) et 20 nm (carrés noirs), et comparaison avec des couches monocristallines de SrVO₃ (30 nm, carrés vides). En insert, dépendance en température de la résistivité montrant le comportement métallique en *T*² des films polycristallins SrVO₃ de 100 nm d'épaisseur et comparaison avec un épi-SrVO₃/LSAT déposé à 600°C.
[Fig. 3] représente : Densité (a) et mobilité (b) des porteurs à 300 K pour les films polycristallins de SrVO₃ déposés sur couche tampon de TiO₂ avec une épaisseur de 100 nm (cercles gris) et 20 nm (carrés noirs), et comparaison avec les couches monocristallines de SrVO₃ (carrés vides).
[Fig. 4] représente : Spectres de transmission dans le visible des films minces de SrVO₃/TiO₂/verre et TiO₂/verre en fonction de la température de dépôt pour des couches des SrVO₃ de 100 nm (a) et 20 nm d'épaisseur (b).

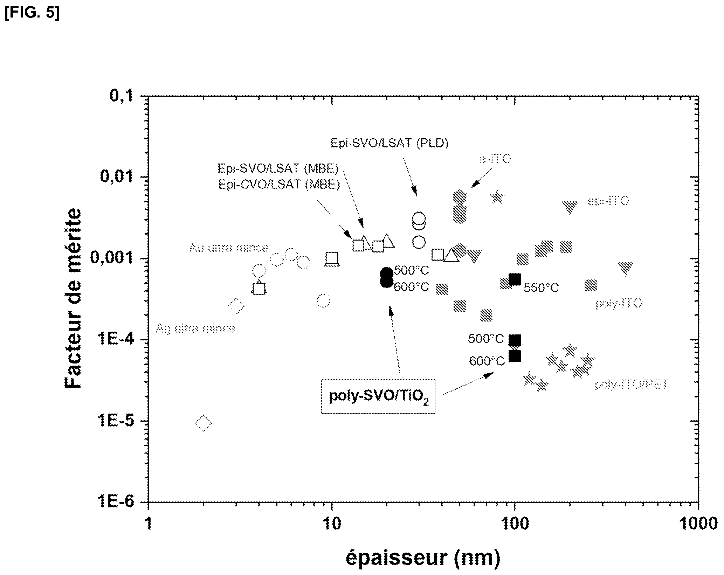

[Fig. 5] représente : Facteur de mérite *Φ*_{TC} des films minces de SrVO₃/TiO₂/verre de 100 et 20 nm d'épaisseur (carrés et cercles noirs remplis), et comparaison avec des films monocristallins de SrVO₃ épitaxiés sur LSAT par PLD (cercles noirs vides) **(Ref. 4),** de SrVO₃ et CaVO₃ épitaxiés sur LSAT par MBE (triangles et carrés noirs vides) **(Ref. 1),** d'ITO monocristallin (triangles gris remplis) **(Refs. 22, 23),** d'ITO polycristallins sur verre (carrés gris remplis) **(Ref. 24),** et sur PET (étoiles grises) **(Ref. 25),** d'ITO amorphe (hexagones gris) **(Ref. 26)** et de couches métalliques ultraminces d'or (cercles gris vides) et d'argent (losanges gris vides) **(Refs. 27, 28).**

### Définitions

Pour faciliter la compréhension de l'invention, un certain nombre de termes et expressions sont définis ci-dessous :
On entend par « indépendamment » au sens de la présente invention, le fait que les substituants, atomes ou groupes auxquels ce terme se réfère, sont choisis parmi la liste des variables indépendamment l'une de l'autre (à savoir, ils peuvent être identiques ou différents).

Comme il sera manifestement apparent à une personne du métier, lorsque les variables énumérées sont regroupées dans un groupe, comme dans un groupe Markush, l'invention englobe non seulement tout le groupe énuméré dans son ensemble, mais chaque membre du groupe individuellement et tous les sous-groupes possibles du groupe principal. Ainsi, il est entendu que l'invention englobe non seulement le groupe principal, mais aussi le groupe principal en l'absence d'un ou de plusieurs des membres du groupe. L'invention prévoit donc l'exclusion explicite d'un ou de plusieurs membres d'un groupe récité. En conséquence, il est entendu que des disclaimers peuvent s'appliquer à l'une quelconque des catégories ou modes de réalisation divulgués dans le présent document, en vertu desquels un ou plusieurs des éléments, variantes ou modes de réalisation récités peuvent être exclus du domaine revendiqué, par exemple, par le biais d'une limitation négative explicite.

### DESCRIPTION DE CERTAINS MODES DE RÉALISATION AVANTAGEUX DE L'INVENTION

Comme discuté précédemment, il existe un réel besoin de développer un moyen permettant la cristallisation des TCO de vanadates, et de manière générale des oxydes métalliques cristallins de type pérovskite, sur tout type de substrats, notamment des substrats inadaptés comme le verre.

La présente invention répond précisément à ce besoin par le biais d'une couche tampon d'un oxyde métallique binaire favorisant la croissance cristalline des oxydes métalliques cristallins de type pérovskite. Dans le présent document, cette couche tampon est également désignée couche (ii) d'un oxyde métallique binaire cristallin.

Ainsi, selon un aspect, l'invention concerne un système conducteur multicouche d'oxydes métalliques tel que défini dans la revendication 1, comprenant :
i. un substrat transparent amorphe ayant une tenue en température de 500°C ;
ii. une couche d'un oxyde métallique binaire cristallin, déposée sur le substrat (i) ; et
iii. une couche d'un oxyde métallique cristallin ayant une structure cristalline de type pérovskite superposée sur la couche d'oxyde métallique binaire (ii).

L'oxyde métallique binaire de la couche (ii) a de préférence un désaccord de maille local à l'interface oxyde métallique pérovskite/oxyde métallique binaire de moins de 5% par rapport à celui de l'oxyde métallique de la couche (iii), sous réserve que lorsque l'oxyde métallique de type pérovskite de la couche (iii) est un oxyde métallique conducteur transparent cristallin, l'épaisseur de la couche d'oxyde métallique binaire cristallin (ii) est < 20 nm, de préférence < 10 nm, tout préférentiellement 5-7 nm. En général, le désaccord de maille local est de préférence inférieur à environ 5%. Ceci permet avantageusement d'induire le transfert de la cristallinité de l'oxyde métallique binaire cristallin de la couche (ii) vers l'oxyde métallique conducteur cristallin de type pérovskite en croissance (couche (iii)). Par « désaccord de maille local », on entend la différence entre les distances interréticulaires des orientations cristallines du film ( ${d}_{hkl}^{\left(iii\right)}$) de la couche (iii) d'oxyde métallique de type pérovskite et de l'oxyde binaire de la couche (ii) ( ${d}_{hkl}^{\left(ii\right)}$) qui sont parallèles localement (i.e., à l'interface couche (ii)/couche (iii)). Le désaccord de maille local d est calculé à partir de l'équation (1) : $d = \frac{{d}_{hkl}^{\left(iii\right)} - {d}_{hkl}^{\left(ii\right)}}{{d}_{hkl}^{\left(ii\right)}} ∗ 100$ (Eq. 1)

L'ensemble des distances interréticulaires d'un cristal est directement mesurable par diffraction (de rayons X par exemple) grâce à la loi de Bragg. Les paramètres de maille, et distances interréticulaires, des oxydes métalliques cristallins de type pérovskite sont connus ou peuvent être déterminés par diffraction aux rayons X. Il en est de même pour les oxydes métalliques binaires cristallins. Ainsi, en fonction de l'oxyde métallique de type pérovskite à déposer sous forme cristalline en couche mince, la personne du métier saura sélectionner les oxydes métalliques binaires adaptés, ayant des paramètres de maille proches de ceux de l'oxyde métallique cristallin de type pérovskite d'intérêt. La personne du métier pourra en particulier choisir les oxydes métalliques binaires dont la distance interréticulaire des orientations cristallines dans le plan du substrat (i.e., parallèle au substrat) diffère de moins de 5% de la distance interréticulaire des orientations cristallines de l'oxyde métallique cristallin de type pérovskite parallèles localement (à l'interface oxyde métallique pérovskite/oxyde métallique binaire). Avantageusement, l'oxyde métallique de type pérovskite de la couche (iii) peut être un oxyde métallique conducteur cristallin ayant une structure cristalline de type pérovskite. Ceci pourra être particulièrement avantageux pour toutes les applications nécessitant/impliquant une conduction électrique telles que les capteurs ou détecteurs optiquement transparents, les capteurs ou détecteurs bioélectroniques, la micro/nano-structuration des dispositifs optiques mais également la technologie des écrans pour les écrans tactiles, les cellules solaires, les afficheurs à cristaux liquides, les diodes électroluminescentes, les diodes électroluminescentes organiques, les dispositifs de chauffage de vitres, miroirs ou lentilles etc... Selon un aspect, la présente invention appartient donc au domaine des conducteurs et notamment des conducteurs transparents dans le domaine du visible et du proche infrarouge, plus particulièrement dans le domaine du visible. Par « oxyde métallique conducteur » on entend un oxyde métallique électriquement conducteur. Dans le cadre de la présente invention, les expressions « conducteur de l'électricité » et « conducteur » sont équivalentes et peuvent être utilisées de façon interchangeable. Le caractère conducteur d'un oxyde métallique de type pérovskite selon l'invention peut être mis en évidence et caractérisé en utilisant la méthode quatre pointes (A, B, C, D) en configuration Van der Pauw. Brièvement, la résistance dépendant des différentes bornes (A, B, C, D) de chaque tension mesurée sur la couche mince est calculée. Une résistance moyenne dépendant du point A (moyenne de la résistance de Vab, Vac et Vda) et du point B (Vbc, Vcd et Vbd) appelées *R_{A}* et *R_{B}* sont calculées. D'après la méthode Van der Pauw, la résistance surfacique *R_{S}* se déduit de la résolution de l'équation (2) en incorporant les valeurs de R_{A} et R_{B} : $exp \left(-{πR}_{A}/{R}_{S}\right) + exp \left(-{πR}_{B}/{R}_{S}\right) = 1$ (Eq. 2)

La résistivité ρ est calculée à partir de l'épaisseur e de la couche mince, par l'équation (3) : $ρ = {R}_{S} . e$ (Eq. 3)

### A. Oxyde métallique conducteur cristallin de structure pérovskite ABO₃

D'une manière générale, l'oxyde métallique de la couche (iii) peut être tout oxyde métallique conducteur de structure pérovskite de formule ABO₃. Le lecteur pourra par exemple se référer à la **Ref 29** pour un enseignement sur les oxydes métalliques conducteurs de structure pérovskite de formule ABO₃. Il peut s'agir d'un oxyde métallique conducteur ou semi-conducteur. Il peut s'agir par exemple, de CaRuO₃, SrRuO₃, SrCrO₃, SrFeO₃, SrTiO₃, SrMoO₃, LaTiO₃, Sr₂VMoO₆, LaNiO₃, des oxydes métalliques hautement conducteurs de type pérovskite. L'oxyde métallique conducteur mis en oeuvre dans le cadre de la présente invention peut être opaque ou transparent dans le visible et le proche infrarouge. Par « oxyde métallique transparent dans le visible et le proche infrarouge », on entend, dans le cadre de la présente invention, un oxyde métallique permettant la transmission d'au moins 70%, voire au moins 80%, d'une lumière présentant une longueur d'onde comprise entre environ 400 et environ 1400 nm et notamment entre environ 400 et environ 800 nm, notamment lorsque l'oxyde métallique est déposé en couche mince de quelques centaines de nanomètres d'épaisseur. La transparence du matériau peut être exprimée avec la valeur (T) de la transmission à une longueur d'onde donnée dans le visible et le proche infrarouge (i.e. de 400 nm à 1400 nm), ou dans le domaine du visible *(i.e.* de 400 nm à 800 nm). Par exemple, la transparence du matériau peut être exprimée avec la valeur (*T*) de la transmission à 550nm. Ainsi, un oxyde métallique sera dit transparent dans le visible et le proche infrarouge, ou dans le visible, si T ≥ 70%, voire T ≥ 80%, lorsqu'exposé en couche mince à une lumière de longueur d'onde entre 400-1400 nm, ou 400-800 nm, respectivement.

Par « opaque dans le visible et le proche infrarouge », on entend, dans le cadre de la présente invention, un oxyde métallique ne permettant pas la transmission d'une lumière présentant une longueur d'onde comprise entre environ 400 et environ 1400 nm et notamment entre environ 400 et environ 800 nm, notamment lorsque l'oxyde métallique est déposé en couche mince de quelques centaines de nanomètres d'épaisseur. La transparence ou l'opacité d'un oxyde métallique peut être déterminée par spectroscopie de transmission en déposant le matériau en couche mince de 1-200 nm, voire 20-100 nm, d'épaisseur, et en mesurant le % de transmission de la lumière incidente à travers la couche mince en fonction de la longueur d'onde. Typiquement, une mesure de transmission est également réalisée avec le substrat ou substrat/couche tampon (ii) seul (sans couche mince (iii) de l'oxyde métallique étudié), puis on corrige les valeurs obtenues sur l'échantillon (substrat/couche tampon (ii)/couche mince (iii)) pour déterminer la transparence de l'oxyde métallique de la couche (iii). L'épaisseur des couches minces d'oxyde métallique peut être déterminée par des méthodes usuelles, par exemple à l'aide d'un profilomètre (pour des épaisseurs de quelques dizaines de nm à quelques centaines de nm), ou par réflectométrie de Rayons X (XRR) pour des épaisseurs de quelques nm à une centaine de nm ou par diffraction des rayons X (DRX) pour des épaisseurs de quelques dizaines de nm à quelques centaines de nm. L'épaisseur des couches minces d'oxyde métallique peut être ajustée au moment de la préparation de la couche mince, par exemple, en ajustant le nombre d'impulsions de laser sur la cible de précurseur d'oxyde métallique, lorsque la mise en oeuvre de la couche mince est réalisée par ablation laser pulsée (cf. Exemples).

Parmi les oxydes métalliques de type pérovskite conducteurs opaques, on pourra mentionner par exemple SrFeO₃, Sr₂VMoO₆, SrCrO₃ et SrTiO₃ (SrCrO₃ et SrTiO₃ semblent devenir opaques dans la phase conductrice). On notera toutefois que certains reconnaissent la bicouche SrTiO₃/LaAlO₃ comme conducteur transparent. Ainsi, SrTiO₃ pourrait être utilisé comme oxyde métallique conducteur transparent dans le cadre de la présente invention. Dans ce cas, on préférera l'utiliser en couche très mince afin d'assurer la transparence optique du système multicouche (e.g. l'épaisseur du SrTiO₃ peut être < 10 nm).

Préférence sera donnée aux oxydes métalliques conducteurs transparents dans le visible et le proche infrarouge de type pérovskite. Ainsi, l'oxyde métallique conducteur mis en œuvre dans le cadre de la présente invention peut être un oxyde transparent et conducteur (TCO). Le lecteur pourra par exemple se référer à la **Ref 1** pour un enseignement sur les oxydes métalliques transparents conducteurs de structure pérovskite de formule ABO₃. De préférence, l'oxyde métallique de la couche (iii) peut être tout oxyde métallique conducteur transparent de structure pérovskite de formule ABO₃ dans laquelle A est choisi parmi Sr ou Ca éventuellement dopé avec La ou un autre élément des groupes des lanthanides tels que Pr, Nd, et B est choisi parmi V, Cr, Ti ou Mo. Il peut s'agir par exemple des oxydes métalliques transparents SrVO₃, CaVO₃, SrMoO₃ ainsi que les solutions solides (La,Sr)VO₃ et (La,Sr)CrO₃ qui sont des conducteurs transparents type p. Il est entendu que l'oxyde métallique conducteur transparent de la couche (iii) répondant à la formule ABO₃ peut être dopé sur le site A avec Ca, Sr, La, ou autres lanthanides ; et/ou sur le site B avec Ti, Cr, Mo, ou autres métaux de transition. Par exemple, SrVO₃, SrCrO₃ et SrMoO₃ peuvent être dopés avec Ca, La, ou autres lanthanides sur le site « Sr ». CaVO₃ peut être dopé sur le site « Ca » avec Sr, La, ou autres lanthanides et/ou sur le site « V » avec Ti, Cr ou Mo. Les dopages peuvent être ajustés pour assurer la conductivité de la pérovskite. Par exemple, concernant SrVO₃, les gammes de dopage pour avoir un conducteur peuvent être de x > 0.26 dans La₁₋ₓSrₓVO₃. En ce qui concerne SrCrO₃, les gammes de dopage pour avoir un conducteur peuvent être de x > 0.5 pour La₁₋ₓSrₓCrO₃. De manière générale, les oxydes métalliques dopés transparents conducteurs de type pérovskite sont connus, ainsi que les gammes de dopage adaptées pour obtenir un oxyde métallique transparent conducteur de type pérovskite. On pourra par exemple mentionner les **Refs 1, 30, 31.**

La couche (iii) d'oxyde métallique conducteur transparent peut avoir une épaisseur de 20 à 100 nm, de préférence 20 à 70 nm, plus préférentiellement 30 à 50 nm.

Lorsque l'oxyde métallique de type pérovskite de la couche (iii) est un oxyde métallique conducteur transparent cristallin, l'épaisseur de la couche d'oxyde métallique binaire cristallin (ii) est < 20 nm, de préférence < 10 nm, tout préférentiellement 5-7 nm, afin d'assurer la transparence optique du système multicouche.

Avantageusement, la couche (iii) d'oxyde métallique de type pérovskite peut être recouverte, en tout ou partie, d'une couche protectrice (cp), de préférence transparente. Il peut s'agir d'un oxyde métallique conducteur, tel que TiO₂ ou ZnO sub-stœchiométrique en O. Dans le présent document, « TiO₂ ou ZnO sub-stœchiométrique en O » se réfère à TiO₂ sub-stœchiométrique en O ou ZnO sub-stœchiométrique en O. La stœchiométrie du TiO₂ ou du ZnO peut être ajustée en adaptant les quantités de composés de départ utilisés pour sa synthèse. Il peut aussi s'agir d'un oxyde métallique isolant, tel que Al₂O₃, SiO₂ ou LaAlO₃. Préférence sera donnée aux couches protectrices très fines (quelques nanomètres), par exemple 1-20 nm d'épaisseur, de préférence < 10 nm, tout préférentiellement 5-7 nm. Alternativement, on pourra opter pour un procédé de dépôt de la couche protectrice (cp) prévoyant l'ouverture de contacts électriques dans la couche protectrice (cp) pour assurer la conductivité dans l'ensemble du système.

Ainsi, un système conducteur multicouche selon l'invention peut comprendre un substrat transparent (i), une couche d'oxyde métallique binaire cristallin (ii) d'épaisseur < 20 nm, de préférence < 10 nm, tout préférentiellement 5-7 nm , et une couche (iii) comprenant un oxyde métallique conducteur transparent cristallin de type pérovskite, dans lequel le système comprend en outre une couche transparente (ct) superposée sur la couche (iii) d'oxyde métallique conducteur, d'un oxyde métallique, de préférence conducteur, tel que TiO₂ ou ZnO sub-stœchiométrique en O, ou un oxyde isolant tel que Al₂O₃, SiO₂ ou LaAlO₃, la couche (ct) recouvrant tout ou partie de la couche (iii). Lorsque la couche (ct) recouvre complètement la couche (iii) d'oxyde métallique conducteur transparent, une épaisseur très fine de la couche (ct) pourra être privilégiée, pour assurer la transparence du système. Alternativement, la couche (ct) peut recouvrir une partie de la couche (iii), avec l'ouverture de contacts électriques dans la couche transparente (ct) pour assurer la conductivité de l'ensemble. Ceci pourra être particulièrement avantageux lorsque la couche (ct) comprend un oxyde métallique isolant tel que Al₂O₃, SiO₂ ou LaAlO₃. La fonction principale de la couche (ct) étant de servir de couche protectrice, la couche (ct) peut être cristalline ou amorphe (l'état cristallin n'est pas indispensable).

La structure cristalline des oxydes métalliques transparents conducteurs de type pérovskite ne correspond pas forcément à la structure pérovskite cubique idéale. Ces oxydes peuvent s'écarter de cette structure cubique idéale selon la nature chimique des cations A et B, par exemple en raison d'une distorsion de la maille, rotation des octaèdres autour d'un axe, etc. Ce peut être le cas par exemple des oxydes métalliques dopés sur le site A et/ou B, la substitution d'un atome par un autre de nature et de taille différente peut entraîner une distorsion de la maille.

Ainsi, l'oxyde métallique binaire de la couche (ii) cristallisera de préférence dans le même type de réseau, avec un paramètre de maille très proche de celui de l'oxyde métallique de type pérovskite de la couche (iii). Comme discuté précédemment, le désaccord de maille local est inférieur à environ 5%. Avantageusement, l'oxyde métallique binaire de la couche (ii) présentera un désaccord de maille local de moins de 5% par rapport à celui l'oxyde métallique transparent conducteur ABO₃ de structure pérovskite de la couche (iii). L'oxyde métallique binaire de la couche (ii) pourra par exemple être choisi parmi TiO₂, SnO₂ ou ZnO. Bien entendu, la couche (ii) d'oxyde métallique binaire sera avantageusement déposée dans des conditions expérimentales adaptées pour permettre le dépôt de l'oxyde métallique sous forme cristalline. Par exemple, des conditions de température adaptées seront avantageusement utilisées pour favoriser la cristallisation de l'oxyde binaire sur le substrat (i) **(Ref 32).** Par exemple, si l'oxyde binaire estTiO₂, ce dernier peut être déposé par pulvérisation cathodique radiofréquence (RF) à 600°C. Ceci peut être réalisé par exemple en pulvérisant une cible métallique de Ti dans un mélange O₂/Ar 10/90% sous une pression adaptée (p.ex. 10⁻² mbar). TiO₂ sub-stoechiométrique, qui a l'avantage d'être conducteur, peut être préparé en ajustant le taux de O₂. Une couche (ii) de TiO₂ sub-stœchiométrique pourra avantageusement être mise en œuvre si une couche (ii) conductrice est souhaitée (p.ex. dans le cas des oxydes ferroélectriques C détaillés ci-dessous).

Bien entendu, la couche (iii) d'oxyde métallique de type pérovskite sera avantageusement déposée dans des conditions expérimentales adaptées pour permettre la croissance cristalline de l'oxyde métallique pérovskite sur la couche (ii) d'oxyde métallique binaire cristallin. Par exemple, des conditions de température adaptées seront avantageusement utilisées pour favoriser la croissance cristalline de l'oxyde métallique pérovskite sur l'oxyde métallique binaire cristallin. **Ref 33** Par exemple, l'oxyde métallique de type pérovskite peut être SrVO₃. Sa croissance cristalline sur un oxyde binaire cristallin, tel que TiO₂, peut être réalisée par ablation laser pulsée à une température de préférence ≥ 450°C, par exemple 450°C-600°C, par exemple 460°C-550°C, par exemple 500-550°C, voire autour de 500°C. Ceci peut être réalisé par exemple en focalisant un laser pulsé sur une cible polycristalline de Sr₂V₂O₇ préparée par réaction standard à l'état solide. Le taux de dépôt (en Å/impulsion) peut être avantageusement ajusté en fonction de la fréquence de répétition du laser, de la fluence sur la cible, la pression de travail, et la distance cible-substrat. (cf. Exemples) L'oxyde métallique de type pérovskite peut être aussi par exemple CaVO₃. Dans ce cas, on pourra par exemple utiliser une cible stœchiométrique en oxygène (c'est-à-dire CaVO₃).

### B. Manganite à magnétorésistance colossale de structure pérovskite Ln₍₁₋ₓ₎ AxMnO₃

D'une manière générale, l'oxyde métallique de la couche (iii) peut être toute manganite à magnétorésistance colossale ("MRC") de structure pérovskite. Le lecteur pourra par exemple se référer à la **Ref 34** pour un enseignement sur les manganites à magnétorésistance colossale ("MRC") de structure pérovskite. L'oxyde métallique de la couche (iii) peut être toute manganite à magnétorésistance colossale ("MRC") de structure pérovskite Ln₍₁₋ₓ₎ AxMnO₃ dans laquelle Ln représente un atome de terre rare (La, Pr, Nd, etc..). Avantageusement, A peut être choisi parmi les atomes alcalinoterreux (Ba, Sr, Ca, etc...). x représente le taux de dopage de l'alcalinoterreux dans la manganite MRC. La magnétorésistance colossale (en anglais, *Colossal Magnetoresistance Effect* ou CMR) est un effet quantique observé dans des matériaux avec des électrons fortement corrélés et notamment les manganites, et se manifeste sous forme d'une baisse significative de la résistance observée sous l'application d'un champ magnétique externe. Numériquement, elle est caractérisée par l'équation (4) : $MR = ΔR / {R}_{0} = \left({R}_{H}-{R}_{0}\right) / {R}_{0}$ (Eq. 4) où R₀ et R_{H} représentent les résistances de l'échantillon à une température donnée respectivement en l'absence de champ magnétique et sous un champ magnétique H. Les oxydes de manganèse Ln₍₁₋ₓ₎AₓMnO₃ présentent la structure pérovskite. Celle-ci ne correspond pas forcément à la structure pérovskite cubique idéale. La structure des oxydes de manganèse Ln₍₁₋ₓ₎AₓMnO₃ est le plus souvent de type orthorhombique et peut être décrite par une charpente tridimensionnelle d'octaèdres MnO₆ partageant leurs sommets et formant des cavités dans lesquelles sont insérés les ions Ln³⁺ et A²⁺.

Ainsi, l'oxyde métallique binaire de la couche (ii) cristallisera de préférence dans le même type de réseau, avec un paramètre de maille très proche de celui de l'oxyde métallique de type pérovskite de la couche (iii). Comme discuté précédemment, le désaccord de maille local est inférieur à environ 5%. Avantageusement, l'oxyde métallique binaire de la couche (ii) présentera un désaccord de maille local de moins de 5% par rapport à celui l'oxyde de manganèse Ln₍₁₋ₓ₎AₓMnO₃ de structure pérovskite de la couche (iii). L'oxyde métallique binaire de la couche (ii) pourra par exemple être choisi parmi TiO₂, SnO₂ ou ZnO. Comme décrit dans la partie A ci-dessus, la couche (ii) d'oxyde métallique binaire sera avantageusement déposée dans des conditions expérimentales adaptées pour permettre le dépôt de l'oxyde métallique sous forme cristalline.

Il est entendu que dans les manganites MRC de formule Ln₍₁₋ₓ₎AₓMnO₃ utilisables dans la couche (iii), le site A peut-être un atome alcalinoterreux, éventuellement dopé avec au moins un autre atome alcalinoterreux. Il peut s'agir par exemple, des manganites MRC de la série x=0,30, par exemple les manganites Pr_{0,70}Ca_{0,30-y}Sr_{y}MnO₃, où y représente le taux de dopage en Sr (qui peut être nul), dont la résistance peut être diminuée de quatre à onze ordres de grandeur par application d'un champ magnétique de 6 T. On pourra mentionner par exemple les manganites MRC Pr_{0,70}Ca_{0,25}Sr_{0,05}MnO₃ (y=0,05) et Pr_{0,70}Ca_{0,26}Sr_{0,04}MnO₃ (y=0,04). Les manganites La_{0,70}Ca_{0,30-y}Sr_{y}MnO₃ et Sm_{0,70}Ba_{0,30-y}Sr_{y}MnO₃, où y représente le taux de dopage en Sr (qui peut être nul), peuvent également être mentionnées, par exemple La_{0,70}Ca_{0,11}Sr_{0,9}MnO₃ et Sm_{0,70}Ba_{0,30}SrMnO₃.

Il peut également s'agir par exemple, des manganites MRC de la série x=0,34, par exemple les manganites Pr_{0,66}Ca_{0,34-y}Sr_{y}MnO₃, où y représente le taux de dopage en Sr. On pourra mentionner par exemple les manganites MRC Pr_{0,70}Ca_{0,25}Sr_{0,05}MnO₃ (y=0,05) et Pr_{0,70}Ca_{0,26}Sr_{0,04}MnO₃ (y=0,04).

On pourra citer également les manganites MRC de la série x=0,50 par exemple de type Ln_{0,5}Sr_{0,5-y}Ca_{y}MnO₃, telles que les manganites Pr_{0,5}Sr_{0,5-y}Ca_{y}MnO₃, comme Pr_{0,50}Sr_{0,41}Ca_{0,09}MnO₃.

Il est entendu que dans les manganites MRC de formule Ln₍₁₋ₓ₎AₓMnO₃ utilisables dans la couche (iii), le site Mn peut éventuellement être dopé, par un élément de transition tel que le chrome, le cobalt ou le nickel. On pourra citer par exemple les manganites MRC de type Ln₍₁₋ₓ₎AₓMn₍₁₋ₖ₎CrₖO₃ où k représente le taux de dopage en Cr sur les sites Mn. Il peut s'agir par exemple de la manganite Pr_{0,5}Ca0,5Mn₍₁₋ₖ₎CrₖO₃ où k peut être compris entre 0,01 et 0,06 (par exemple, k peut être 0,01, 0,03, 0,04 ou 0,06).

L'oxyde métallique de la couche (iii) de formule Ln₍₁₋ₓ₎AₓMnO₃ pourra avantageusement être ferromagnétique, notamment à la température d'opération du système multicouche selon la présente invention.

Dans le cas des systèmes à manganite MRC, la transparence n'est pas nécessaire. L'oxyde métallique de la couche (iii) de formule Ln₍₁₋ₓ₎AₓMnO₃ pourra donc être opaque. Il en est de même pour le substrat (i) et la couche d'oxyde métallique binaire cristallin (ii). La couche d'oxyde métallique (iii) de formule Ln₍₁₋ₓ₎AₓMnO₃ peut présenter une épaisseur plus ou moins grande. Cette épaisseur peut être variable sur le substrat. Toutefois, une épaisseur constante sur tout le substrat peut être avantageuse. En particulier, cette épaisseur peut être comprise entre 10 et 1000 nm, notamment entre 20 et 800 nm, en particulier, entre 50 et 600 nm et, plus particulièrement, entre 100 et 400 nm.

En raison de la grande sensibilité des manganites MRC au champ magnétique, les systèmes multicouche selon la présente invention dans lesquels l'oxyde métallique de la couche (iii) peut être une manganite MRC répondant à la formule Ln₍₁₋ₓ₎AₓMnO₃ telle que définie ci-dessus généralement et en différentes variantes, peuvent trouver application pour la réalisation de capteurs par exemple pour l'enregistrement magnétique ou le stockage magnétique de l'information.

### C. Oxyde métallique ferroélectrique de structure pérovskite ABO₃

D'une manière générale, l'oxyde métallique de la couche (iii) peut être tout oxyde métallique ferroélectrique de structure pérovskite. Le lecteur pourra par exemple se référer à la **Ref 35** pour un enseignement sur les oxydes métalliques ferroélectriques de structure pérovskite. L'oxyde métallique de la couche (iii) peut être tout oxyde métallique ferroélectrique de structure pérovskite répondant à la formule ABO₃. Par exemple, A peut être choisi parmi Ba, Pb ou K, et B peut être choisi parmi Ti, Zr ou Ta. Avantageusement, A peut être choisi parmi Ba ou Pb, et B peut être choisi parmi Ti ou Zr.

Par «oxyde métallique ferroélectrique», on entend les oxydes métalliques possédant une polarisation électrique intrinsèque, qu'un champ électrique extérieur peut faire basculer d'une direction à une autre. La plupart des cristaux pyroélectriques possèdent une polarisation spontanée P_{S} dans certains domaines de température et la direction de cette P_{S} peut être inversée par l'application d'un champ électrique externe. Ce caractère appelé « ferroélectrique » est décrit par le cycle d'hystérésis de la polarisation en fonction du champ électrique appliqué. Par «hystérésis» on entend la persistance d'un phénomène lorsque cesse la cause qui l'a provoqué.

Parmi les pérovskites ferroélectriques utilisables dans le cadre de la présente invention, on pourra citer par exemple BaTiO₃, PbTiO₃, BaZrO₃, PbZrO, KNbO₃ et KTaO₃ . En particulier, on pourra citer BaTiO₃, PbTiO₃, BaZrO₃ et PbZrO₃.

Il est entendu que dans les pérovskites ferroélectriques de formule ABO₃ utilisables dans la couche (iii), le site B peut éventuellement être dopé, par un autre atome. Il peut s'agir par exemple de Pb(Zr,Ti)O₃(PZT).

Les pérovskites ferroélectriques peuvent subir plusieurs transformations de phase en fonction de la température. En fonction de la température, on peut observer des déplacements atomiques et distorsions de la maille. Par exemple, le niobate de potassium KNbO₃ (ou KNO) cristallise dans un réseau rhomboédrique avec une polarisation suivant un axe <111> dans son état fondamental (basse température, ≤ 263K). En dessous de sa température de Curie (708K), KNbO₃ peut adopter une structure tétragonale, orthorhombique, ou rhomboédrique, chacune favorisant une polarisation électrique suivant un axe cristallographique différent. C'est le cas pour les pérovskites ferroélectriques en général (i.e., succession de transformations de phase en fonction de la température, avec une évolution vers une structure plus symétrique en augmentant la température; BaTiO₃ montre par exemple une phase cubique à haute température). Ainsi, dans le cas où l'oxyde métallique de la couche (iii) est une pérovskite ferroélectrique de formule ABO₃, l'oxyde métallique binaire de la couche (ii) cristallisera de préférence dans le même type de réseau, à savoir tétragonal, orthorhombique, ou rhomboédrique, en fonction de la température d'opération du système. L'oxyde métallique binaire de la couche (ii) pourra par exemple être choisi parmi au moins l'un des oxydes suivants : TiO₂, SnO₂, ZnO, Y₂O₃, ZrO₂, HfO₂ et Cr₂O₃. Comme décrit dans la partie A ci-dessus, la couche (ii) d'oxyde métallique binaire sera avantageusement déposée dans des conditions expérimentales adaptées pour permettre le dépôt de l'oxyde métallique sous forme cristalline.

Dans le cas des systèmes à oxyde métallique ferroélectrique, la transparence n'est pas nécessaire. En effet, l'utilisation d'un substrat (i) opaque et/ou d'une couche (ii) d'oxyde métallique binaire opaque n'empêche pas les applications primaires des ferroélectriques. L'oxyde métallique ferroélectrique de la couche (iii) de formule ABO₃ pourra donc être opaque. Il en est de même pour la couche d'oxyde métallique binaire cristallin (ii). On notera toutefois qu'en général, les ferroélectriques sont transparents. Ainsi, la possibilité de garder la transparence de la multicouche et du substrat permettra avantageusement d'intégrer le système dans l'électronique transparente. On notera également que la transparence du système impose par contre un substrat isolant (il n'y a pas de substrats conducteurs transparents) ; dans ce cas on pourra prévoir l'utilisation d'une couche (ii) d'oxyde métallique binaire conductrice (p.ex. TiO₂ ou ZnO sub-stœchiométrique) ou d'une couche (iv) supplémentaire conductrice située entre le substrat (i) et la couche (ii) d'oxyde métallique binaire (ceci pour permettre l'élaboration d'un système multi-couche où l'oxyde métallique ferroélectrique (iii) de formule ABO₃ est avantageusement pris en sandwich entre deux couches conductrices - cf. paragraphes ci-dessous).

La couche d'oxyde métallique ferroélectrique (iii) de formule ABO₃ pourra présenter une épaisseur plus ou moins grande. Cette épaisseur peut être variable sur le substrat. Toutefois, une épaisseur constante sur tout le substrat peut être avantageuse. En particulier, cette épaisseur peut être comprise entre 10 et 1000 nm, notamment entre 20 et 800 nm, en particulier, entre 50 et 600 nm et, plus particulièrement, entre 100 et 400 nm.

En revanche, dans le cas des systèmes à oxyde métallique ferroélectrique, la couche d'oxyde métallique ferroélectrique (iii) de formule ABO₃ est de préférence prise en sandwich entre deux couches conductrices. Ainsi, dans une variante, dans le système conducteur multicouche selon l'invention, l'oxyde métallique de type pérovskite de la couche (iii) peut comprendre un oxyde ferroélectrique (C), et l'oxyde métallique binaire de la couche (ii) peut être un oxyde métallique binaire conducteur, le système multicouche comprenant en outre une couche conductrice (cc) superposée sur la couche (iii). Par exemple, la couche (ii) du système multicouche selon l'invention pourra de préférence comprendre un oxyde métallique binaire conducteur tel que comme le TiO₂ ou ZnO sub-stœchiométrique en O. Par ailleurs, une couche conductrice (cc) pourra avantageusement être déposée sur la couche d'oxyde métallique ferroélectrique (iii). Ainsi, lorsque l'oxyde métallique de type pérovskite de la couche (iii) comprend un oxyde ferroélectrique, la couche (ii) peut comprendre un oxyde métallique binaire conducteur tel que comme le TiO₂ ou ZnO sub-stoechiométrique en O, et le système multicouche peut comprendre en outre une couche conductrice (cc) superposée sur la couche (iii). Les couches (ii) et (cc) peuvent être composées de matériaux conducteurs identiques ou différents. Dans une variante, dans le système conducteur multicouche selon l'invention, l'oxyde métallique de type pérovskite de la couche (iii) peut comprendre un oxyde ferroélectrique (C), et l'oxyde métallique binaire de la couche (ii) peut être un oxyde métallique binaire isolant, le système multicouche comprenant en outre une couche conductrice (cc) superposée sur la couche (iii). Dans ce cas, la couche (ii) d'oxyde métallique binaire sera avantageusement fine (p.ex. < 10 nm), et le substrat (i) pourra avantageusement être un substrat conducteur, assurant ainsi la prise en sandwich de l'oxyde ferroélectrique (C) entre deux couches conductrices (le substrat conducteur et la couche conductrice (cc) superposée sur la couche (iii)).

Dans une autre variante, dans le système conducteur multicouche selon l'invention, l'oxyde métallique de type pérovskite de la couche (iii) peut comprendre un oxyde ferroélectrique (C), et l'oxyde métallique binaire de la couche (ii) peut être un oxyde métallique binaire isolant, le système multicouche comprenant en outre une couche conductrice (cc) superposée sur la couche (iii) et un substrat (i) isolant (transparent). Dans ce cas, la couche (ii) d"oxyde métallique binaire sera avantageusement fine (p.ex. < 10 nm), et le système pourra comprendre en outre une couche (iv) supplémentaire conductrice située entre le substrat (i) et la couche (ii) d'oxyde métallique binaire (ceci pour permettre l'élaboration d'un système multi-couche où l'oxyde métallique ferroélectrique (iii) de formule ABO₃ est avantageusement pris en sandwich entre deux couches conductrices).

Dans l'une quelconque des variantes précédentes, la couche conductrice (cc) peut comprendre un matériau conducteur, tel que :
- un oxyde métallique conducteur comme le TiO₂ ou ZnO sub-stœchiométrique en O;
- un oxyde pérovskite conducteur tel que l'un quelconque des oxydes métalliques conducteurs de structure pérovskite ABO₃ mentionnés dans la partie A) ci-dessus. Il peut s'agir notamment d'un oxyde métallique hautement conducteur de type pérovskite tel que CaRuO₃, SrRuO₃, SrCrO₃, SrFeO₃, SrTiO₃, SrMoO₃, LaTiO₃, Sr₂VMoO₆, LaNiO₃, ou d'un oxyde métallique conducteur transparent cristallin répondant à la formule ABO₃ dans laquelle A est choisi parmi Sr ou Ca éventuellement dopé avec La ou un autre élément des groupes des lanthanides, et B est choisi parmi V, Cr, Ti ou Mo, tel que SrVO₃, CaVO₃, SrCrO₃, SrTiO₃, SrMoO₃; ou
- une couche métallique conductrice (p.ex. Au, Ag, Al, ...).

En raison de leurs propriétés ferroélectriques, les systèmes multicouche selon la présente invention dans lesquels l'oxyde métallique de la couche (iii) peut être un oxyde métallique ferroélectrique répondant à la formule ABO₃ telle que définie ci-dessus généralement et en différentes variantes, peuvent trouver de nombreuses applications en microélectronique, comme la réalisation de filtres ou de condensateurs dont les propriétés peuvent être ajustées avec la composition chimique du matériau. Par exemple, les couches minces ferroélectriques sont très utilisées sous la forme de condensateurs électrode/ferroélectrique/électrode dans les mémoires non volatiles FRAMs "non-volatile Ferroelectric Random Access Memories" et volatiles DRAMs "Dynamic Random Access Memories". La couche (iii) peut être déposée par toute méthode d'élaboration de couches minces ferroélectriques connue de l'art. Par exemple, on peut citer le dépôt par pulvérisation cathodique, l'épitaxie par jet moléculaire (molecular beam epitaxy MBE) ou des techniques de dépôt chimique en phase vapeur (CVD) comme l'Épitaxie en phase vapeur aux organométalliques (metalorganic chemical vapour deposition MOCVD), le dépôt de couche mince atomique (Atomic layer deposition (ALD), ou le dépôt par ablation par laser pulsé ("pld" ou "pulsed laser deposition" en anglais).
--------

Ainsi, selon un aspect, la présente invention concerne un système conducteur multicouche d'oxydes métalliques comprenant :
i. un substrat transparent amorphe ayant une tenue en température de 500°C ;
ii. une couche d'un oxyde métallique binaire cristallin, déposée sur le substrat (i) ; et
iii. une couche d'un oxyde métallique conducteur cristallin ayant une structure cristalline de type pérovskite superposée sur la couche d'oxyde métallique binaire (ii);

l'oxyde métallique binaire de la couche (ii) ayant un désaccord de maille local à l'interface oxyde métallique pérovskite/oxyde métallique binaire de moins de 5% par rapport à celui de l'oxyde métallique de la couche (iii) ;
sous réserve que lorsque l'oxyde métallique de type pérovskite de la couche (iii) est un oxyde métallique conducteur transparent cristallin, l'épaisseur de la couche d'oxyde métallique binaire cristallin (ii) est < 20 nm, de préférence < 10 nm, tout préférentiellement 5-7 nm.

Pour la mise en œuvre de la présente invention, l'oxyde métallique de type pérovskite de la couche (iii) peut comprendre :
A. un oxyde métallique conducteur transparent cristallin de structure pérovskite répondant à la formule ABO₃ dans laquelle A est choisi parmi Sr ou Ca éventuellement dopé avec La ou un autre élément des groupes des lanthanides, et B est choisi parmi V, Cr, Ti ou Mo ;
B. une manganite à magnétorésistance colossale de structure pérovskite répondant à la formule Ln₍₁₋ₓ₎AₓMnO₃ dans laquelle Ln représente un atome de terre rare (La, Pr, Nd, etc..), A est choisi parmi les atomes alcalinoterreux (Ba, Sr, Ca, etc...) et x représente le taux de dopage de l'alcalinoterreux; ou
C. un oxyde métallique ferroélectrique de structure pérovskite répondant à la formule ABO₃ dans laquelle A est choisi parmi Ba, Pb ou K, et B est choisi parmi Ti, Zr ou Ta, de préférence A est choisi parmi Ba ou Pb, et B est choisi parmi Ti ou Zr.

La croissance de la couche (iii) d'oxyde métallique de type pérovskite peut être réalisée à une température ≥ 400°C. Par exemple, lorsque l'oxyde métallique de type pérovskite est le SrVO₃, la croissance de la couche (iii) peut être réalisée à une température de préférence ≥ 450°C, par exemple 450°C-600°C, par exemple 460°C-550°C, par exemple 500-550°C, voire autour de 500°C.

Lorsque l'oxyde métallique de type pérovskite de la couche (iii) est un oxyde métallique conducteur transparent cristallin, l'épaisseur de la couche d'oxyde métallique binaire cristallin (ii) est < 20 nm, de préférence < 10 nm, tout préférentiellement 5-7 nm, afin d'assurer la transparence optique du système multicouche.

Dans tous les cas, l'oxyde métallique binaire cristallin de la couche (ii) peut être choisi parmi TiO₂, SnO₂ ou ZnO, de préférence TiO₂.

La couche d'oxyde métallique conducteur (iii) peut présenter une épaisseur plus ou moins grande. Cette épaisseur peut être variable sur la surface de la couche (ii) d'oxyde métallique binaire supportée par le substrat. Toutefois, une épaisseur constante sur toute la surface peut être avantageuse. En particulier, sauf mention contraire, cette épaisseur peut être comprise entre 10 et 1000 nm, notamment entre 20 et 800 nm, en particulier, entre 50 et 600 nm et, plus particulièrement, entre 100 et 400 nm. Dans le cas d'un système conducteur multicouche transparent (cad substrat (i) transparent et couche (iii) = oxyde métallique conducteur transparent), l'épaisseur de la couche (iii) pourra être plus fine pour avoir un bon compromis entre la transparence optique (le plus fin, le mieux) et la résistivité (le plus épais, le mieux). Par exemple, une épaisseur de 20 à 100 nm, de préférence 20 à 70 nm, plus préférentiellement 30 à 50 nm pourra être avantageusement réalisée.

L'homme du métier connait différentes techniques permettant le dépôt d'une telle couche d'un oxyde métallique sur un support, ladite couche étant en contact direct avec la surface du support. A titre d'exemples illustratifs et non limitatifs, on peut citer les techniques de dépôt de couche mince, telle que la pulvérisation cathodique sous vide, l'épitaxie par jet moléculaire (molecular beam epitaxy MBE) ou des techniques de dépôt chimique en phase vapeur (CVD) comme l'Épitaxie en phase vapeur aux organométalliques (metalorganic chemical vapour deposition MOCVD), le dépôt de couche mince atomique (Atomic layer deposition ALD), ou le dépôt par ablation par laser pulsé ("pld" ou "pulsed laser deposition" en anglais). L'ensemble des techniques précitées sont applicables au dépôt :
- de la couche (ii) d'oxyde métallique binaire sur le substrat (i)
- de la couche (iii) d'oxyde métallique de type pérovskite sur la couche (ii)
- d'une éventuelle couche protectrice (cp) sur la couche (iii) ou sur la couche conductrice (cc)
- d'une éventuelle couche conductrice (cc) sur la couche (iii) (cf. discussion ci-dessus des oxydes métalliques ferroélectriques de type pérovskite).

### Substrat

Avantageusement, le substrat (i) sur lequel les différentes couches de matériau sont déposées sous forme de couche mince, peut être tout substrat adapté. Le substrat choisi dépendra de la mise en forme finale du système multicouche visé, de son procédé de préparation notamment de la température appliquée pour les opérations de manufacture du système (le substrat devant être adapté à la température à laquelle il est soumis), et de l'application envisagée. Avantageusement, le substrat est transparent, tel que le verre ou un plastique transparent. Cette mise en forme est particulièrement adaptée à une application nécessitant une transparence optique du système.

Tout substrat adapté est utilisable dans le cadre de la présente invention, ce dernier pouvant notamment être en polymère(s) ou se présenter sous forme d'une couche inorganique. Ainsi, le substrat (i) mis en œuvre dans le cadre de la présente invention i.e. le substrat à la surface duquel les différentes couches d'oxyde métallique sont déposées, peut être tout substrat solide naturel ou synthétique, notamment utilisé comme substrat d'empilement multicouche d'oxydes métalliques.

Avantageusement, le substrat mis en œuvre dans le cadre de la présente invention peut être un substrat isolant (p.ex. le verre) ou conducteur ou semi-conducteur.

De même, ce substrat est transparent dans le visible et le proche infrarouge. Par «substrat transparent dans le visible et le proche infrarouge », on entend, dans le cadre de la présente invention, un substrat d'un matériau permettant la transmission d'au moins 50%, notamment d'au moins 60%, en particulier, d'au moins 70%, plus particulièrement d'au moins 80%, encore plus particulièrement d'au moins 85%, voire d'au moins 90%, d'une lumière présentant une longueur d'onde comprise entre environ 400 et environ 1400 nm et notamment entre environ 400 et environ 800 nm (domaine du visible).

Plus particulièrement, le substrat mis en œuvre dans le cadre de la présente invention peut être un substrat en verre ou un substrat polymère transparent dans le visible et le proche infrarouge, tel qu'un substrat en polymère flexible transparent dans le visible et le proche infrarouge. Les substrats en polymère flexible transparent dans le visible et le proche infrarouge peuvent être avantageux par exemple dans les applications telles que les écrans ou la photovoltaïque flexibles. Ainsi, le substrat mis en œuvre dans le cadre de la présente invention peut être en un matériau choisi dans le groupe constitué par le verre, un polycarbonate tel que le bisphénol A polycarbonate, un polyacrylate tel que le poly(méthyl méthacrylate), un polyamide tel que le nylon, un polyester tel que le polyéthylène téréphtalate (PET), un polyarylate, un polyetherimide, un polymère sulfonique, un polyéther imide, un polyimide, un polynorbornène, un polymère oléfinique, un polymère liquide cristallin (ou LCP) tel que du polyétheréthercétone (ou PEEK), du polyphénylène éther (ou PPE) ou du polyphénylène oxyde (ou PPO) et un polymère thermodurcissable transparent. Avantageusement, le substrat transparent (i) est un matériau transparent amorphe ayant une tenue en température de 500°C, tel que le verre.

Ainsi, le système multicouche selon l'invention peut être un système conducteur transparent multicouche, et peut comprendre :
i. un substrat optiquement transparent, notamment dans le visible et le proche infrarouge, plus particulièrement dans le visible ;
ii. une couche d'un oxyde métallique binaire cristallin, déposée sur le substrat (i) ; et
iii. une couche d'un oxyde métallique conducteur cristallin, éventuellement transparent dans le visible et le proche infrarouge, plus particulièrement dans le visible, ayant une structure cristalline de type pérovskite superposée sur la couche d'oxyde métallique binaire (ii);

l'oxyde métallique binaire de la couche (ii) ayant un désaccord de maille local à l'interface oxyde métallique pérovskite/oxyde métallique binaire de moins de 5% par rapport à celui de l'oxyde métallique de la couche (iii) ;
sous réserve que lorsque l'oxyde métallique de type pérovskite de la couche (iii) est un oxyde métallique conducteur transparent cristallin, l'épaisseur de la couche d'oxyde métallique binaire cristallin (ii) est < 20 nm, de préférence < 10 nm, tout préférentiellement 5-7 nm.

Avantageusement, un tel système conducteur multicouche peut avoir une transparence optique dans le visible > 70%, de préférence ≥ 75%. Ceci peut être accompli par l'utilisation d'un substrat (i) et d'une couche (ii) d'un oxyde métallique conducteur cristallin de type pérovskite, le substrat et l'oxyde métallique étant optiquement transparents dans le visible et le proche infrarouge, plus particulièrement dans le visible. L'oxyde métallique conducteur transparent cristallin de type pérovskite peut être tels que ceux décrits dans la partie A par exemple.

### Composant électronique

Selon un autre aspect, l'invention concerne un composant électronique comprenant un système conducteur multicouche selon l'invention, dans l'une quelconque des variantes décrites dans la présente description.

### Procédé de préparation

Selon un autre aspect, l'invention concerne un procédé de préparation d'un système conducteur multicouche selon l'invention, comprenant:
(a) le dépôt sur un substrat (i) transparent amorphe ayant une tenue en température de 500°C, d'une couche (ii) d'un oxyde métallique binaire cristallin ; et
(b) la croissance cristalline d'une couche (iii) d'un oxyde métallique conducteur cristallin sur la couche (ii) d'oxyde binaire cristallin obtenue à l'étape a), l'oxyde métallique conducteur ayant une structure cristalline de type pérovskite. Avantageusement, l'oxyde métallique binaire de l'étape a) a un désaccord de maille local à l'interface oxyde métallique pérovskite/oxyde métallique binaire de moins de 5% par rapport à celui de l'oxyde métallique conducteur cristallin de type pérovskite de l'étape b).

Lorsque l'oxyde métallique de type pérovskite de la couche de l'étape b) est un oxyde métallique conducteur transparent cristallin, l'épaisseur de la couche d'oxyde métallique binaire cristallin de l'étape a) est < 20 nm, de préférence < 10 nm, tout préférentiellement 5-7 nm.

Avantageusement, l'étape a) peut être réalisée par une technique de dépôt de couche mince. Par exemple, on pourra citer à titre illustratif, la pulvérisation cathodique sous vide, l'épitaxie par jet moléculaire (molecular beam epitaxy MBE), par ablation par laser pulsé ("pld" ou "pulsed laser deposition" en anglais) ou des techniques de dépôt chimique en phase vapeur (CVD) comme l'Épitaxie en phase vapeur aux organométalliques (metalorganic chemical vapour deposition MOCVD) ou le dépôt de couche mince atomique (Atomic layer deposition (ALD).

Avantageusement, l'étape b) peut être réalisée à une température ≥ 400°C, de préférence par ablation par laser pulsé ("pld" ou "pulsed laser deposition" en anglais), par pulvérisation cathodique sous vide, par épitaxie par jet moléculaire ou par des techniques de dépôt chimique en phase vapeur comme l'Épitaxie en phase vapeur aux organométalliques ou le dépôt de couche mince atomique, tout préférentiellement par ablation par laser pulsé ou par pulvérisation cathodique sous vide. Par exemple, lorsque l'oxyde métallique de type pérovskite est le SrVO₃, la croissance de la couche (iii) peut être réalisée à une température de préférence ≥ 450°C, par exemple 450°C-600°C, par exemple 460°C-550°C, par exemple 500-550°C, voire autour de 500°C.

### Empilement avec Oxyde métallique conducteur cristallin de structure pérovskite ABO₃ (A) ou Manganite MRC de structure pérovskite Ln₍₁₋ₓ₎AₓMnO₃ (B)

Eventuellement, le procédé peut comprendre en outre une étape (c) de revêtement de la couche (iii) d'oxyde métallique conducteur obtenue en b) avec une couche protectrice (cp), éventuellement transparente.

La couche obtenue en c) peut recouvrir tout ou partie de la couche d'oxyde métallique conducteur obtenue en b). C'est-à-dire que la couche obtenue en c) peut recouvrir totalement la couche d'oxyde métallique conducteur obtenue en b). Alternativement, la couche de l'étape c) peut être réalisée en prévoyant des ouvertures de contacts électriques dans la couche protectrice (cp) pour assurer la conductivité de l'ensemble.

Ceci pourra être avantageusement envisagé dans le cas des systèmes multicouche selon l'invention où la couche (iii) d'oxyde métallique comprend un oxyde métallique conducteur de structure pérovskite de formule ABO₃, transparent ou opaque, tels que ceux détaillés dans la partie A, ou bien une manganite MRC de structure pérovskite de formule Ln₍₁₋ₓ₎AₓMnO₃, telles que celles détaillées dans la partie B.

Avantageusement, la couche protectrice (cp) peut comprendre un oxyde métallique, de préférence conducteur, tel que TiO₂ ou ZnO sub-stœchiométrique en O, ou un oxyde isolant tel que Al₂O₃, SiO₂ et LaAlO₃. Ceci pourra avantageusement être envisagé dans le cas des systèmes multicouche selon l'invention où la couche (iii) d'oxyde métallique comprend un oxyde métallique conducteur transparent de structure pérovskite de formule ABO₃, tels que ceux détaillés dans la partie A.

### Empilement avec pérovskite ferroélectrique de structure ABO₃(C)

Eventuellement, le procédé peut comprendre en outre une étape (b1) de revêtement de la couche (iii) d'oxyde métallique conducteur obtenue en b) avec une couche conductrice (cc). Ceci sera particulièrement avantageux dans le cas où l'oxyde métallique conducteur est une pérovskite ferroélectrique de structure ABO₃, telle que celles détaillées dans la partie C. Pour le choix du matériau de la couche conductrice (cc) et sa mise en oeuvre, on pourra se référer à la partie C « Oxyde ferroélectrique de structure pérovskite ABO₃ » détaillée plus haut.

Eventuellement, le procédé peut comprendre en outre une étape (c1) de revêtement de la couche conductrice (cc) obtenue en b1) avec une couche protectrice (cp). La couche obtenue en c1) peut recouvrir tout ou partie de la couche conductrice (cc) obtenue en b1). C'est-à-dire que la couche obtenue en c1) peut recouvrir totalement la couche conductrice (cc) obtenue en b1). Alternativement, la couche de l'étape c1) peut être réalisée en prévoyant des ouvertures de contacts électriques dans la couche protectrice (cp) pour assurer la conductivité de l'ensemble.

### Couche protectrice (cp)

Ainsi, quel que soit le type d'empilement considéré (système utilisant A) un oxyde métallique conducteur cristallin de structure pérovskite ABO₃, B) une manganite MRC de structure pérovskite Ln₍₁₋ₓ₎AₓMnO₃, ou bien C) un oxyde métallique ferroélectrique de structure pérovskite ABO₃), une couche protectrice (cp) peut être déposée sur l'empilement de multicouches recouvrant le substrat. La couche protectrice (cp) peut être en matériau isolant, semi-conducteur (p.ex. un semi-conducteur de type n ou de type p) ou conducteur selon l'application visée. Dans le cas d'un matériau isolant, la mise en oeuvre de la couche protectrice (cp) peut être réalisée en prévoyant des ouvertures de contacts électriques dans la couche protectrice (cp) pour assurer la conductivité de l'ensemble, par exemple en apposant un ou plusieurs caches sur la surface de la couche à recouvrir avec la couche protectrice (cp), lesquels caches pouvant être retirés une fois la couche protectrice (cp) déposée. A titre d'exemples de matériaux susceptibles d'être déposés sur la couche (iii) d'oxyde métallique conducteur de type pérovskite, on peut citer par exemple l'oxyde de titane (TiO₂) éventuellement dopé, l'oxyde de zinc (ZnO) éventuellement dopé, l'oxyde de silicium (SiO₂), Al₂O₃, LaAlO₃, l'oxyde de nickel (NiO), l'oxyde d'indium éventuellement dopé, l'oxyde d'étain éventuellement dopé, l'oxyde de cadmium éventuellement dopé, l'oxyde de gallium éventuellement dopé, l'oxyde de thallium éventuellement dopé, l'oxyde de plomb éventuellement dopé, l'oxyde d'antimoine éventuellement dopé, l'oxyde de magnésium éventuellement dopé, l'oxyde de niobium éventuellement dopé, l'oxyde de tungstène éventuellement dopé, l'oxyde de zirconium et leurs mélanges ; du fluorure de graphite ; du nitrure de silicium ; un matériau organique, notamment choisi dans le groupe constitué par les polymères. A titre de polymère pour l'élaboration de la couche protectrice (cp), il pourra s'agir par exemple d'un polymère transparent dans le visible et le proche infrarouge tel qu'un substrat en polymère flexible transparent dans le visible et le proche infrarouge. Le polymère peut être choisi par exemple parmi un polycarbonate tel que le bisphénol A polycarbonate, un polyacrylate tel que le poly(méthyl méthacrylate), un polyamide tel que le nylon, un polyester tel que le polyéthylène téréphtalate (PET), un polyarylate, un polyetherimide, un polymère sulfonique, un polyéther imide, un polyimide, un polynorbornène, un polymère oléfinique, un polymère liquide cristallin (ou LCP) tel que du polyétheréthercétone (ou PEEK), du polyphénylène éther (ou PPE) ou du polyphénylène oxyde (ou PPO) et un polymère thermodurcissable transparent.

L'homme du métier connaît différents protocoles permettant d'obtenir le dépôt d'une couche d'un matériau tel que précédemment défini sur une couche d'oxyde métallique conducteur. A titre d'exemples illustratifs et non limitatifs de tels protocoles, on peut citer le spin-coating, le casting, l'électrogreffage, le greffage chimique et le dépôt par évaporation.

### Utilisations

Le système multicouche selon l'invention peut avantageusement être utilisé dans une variété d'applications, notamment dans tout domaine d'application des :
- oxydes métalliques conducteurs cristallins de structure pérovskite_répondant à la formule ABO₃, transparents ou opaques, tels que ceux détaillés dans la partie A) ;
- manganites à magnétorésistance colossale de structure pérovskite répondant à la formule Ln₍₁₋ₓ₎AₓMnO₃ telles que celles détaillées dans la partie B) ; et/ou
- oxydes métalliques ferroélectriques de structure pérovskite répondant à la formule ABO₃ tels que ceux détaillés dans la partie C).

Ainsi, un système conducteur multicouche selon l'invention pourra être utilisé notamment :
- en optoélectronique;
- dans les technologies solaires tels que les cellules ou panneaux photovoltaïques;
- dans la technologie des capteurs, tels que les capteurs tactiles;
- dans les technologies d'affichage tels que les écrans à cristaux liquides, les écrans plats, les écrans plasma, et les écrans tactiles;
- dans les revêtements réflecteurs à infrarouge tels que le filtres/miroirs infrarouges ou les vitres/vitrages à faible émissivité;
- dans le blindage électromagnétique;
- dans l'électronique transparente;
- dans les antennes intégrées; et/ou
- dans les substrats conducteurs pour les circuits intégrés.

A titre d'exemples, la présente invention peut être mise en œuvre dans l'industrie des cellules photovoltaïques et dans l'industrie électronique en vue de fabriquer des faces avant ou des faces arrière d'écrans émissifs du type écran plat, écran dit plasma ou encore des écrans tactiles et plus généralement tout type de d'écran/vitrage susceptible de recevoir, de transmettre ou d'émettre des rayonnements, notamment de la lumière visible.

Une couche mince d'oxyde métallique binaire cristallin peut être utilisée comme couche de germination pour la croissance cristalline d'un oxyde métallique ayant une structure cristalline de type pérovskite, l'oxyde métallique binaire ayant un désaccord de maille local à l'interface oxyde métallique pérovskite/oxyde métallique binaire de moins de 5% par rapport à celui de l'oxyde métallique de type pérovskite. Un procédé de croissance cristalline d'un oxyde métallique ayant une structure cristalline de type pérovskite, comprend la mise en œuvre d'une couche d'oxyde métallique binaire comme couche de germination, l'oxyde métallique binaire ayant un désaccord de maille local de moins de 5% par rapport à celui de l'oxyde métallique de type pérovskite. L'oxyde métallique de type pérovskite peut être choisi parmi les :
- oxydes métalliques conducteurs cristallins de structure pérovskite_répondant à la formule ABO₃, transparents ou opaques, tels que ceux détaillés dans la partie A) ;
- manganites à magnétorésistance colossale de structure pérovskite répondant à la formule Ln₍₁₋ₓ₎AₓMnO₃ telles que celles détaillées dans la partie B) ; ou
- oxydes métalliques ferroélectriques de structure pérovskite répondant à la formule ABO₃ tels que ceux détaillés dans la partie C).

### EQUIVALENTS

Les exemples représentatifs qui suivent sont destinés à illustrer l'invention et ne sont pas destinés à limiter la portée de l'invention, ni ne doivent être interprétés comme tels. En effet, diverses modifications de l'invention et de nombreux autres modes de réalisation de celle-ci, en plus de celles présentées et décrites ici, apparaîtront à la personne du métier à partir de l'ensemble du contenu de ce document, y compris les exemples qui suivent.

Les exemples qui suivent contiennent des informations importantes supplémentaires, d'exemplification et d'enseignement qui peuvent être adaptés à la pratique de cette invention dans ses divers modes de réalisation et les équivalents de ceux-ci.

Les exemples suivants sont donnés à titre indicatif et sans aucun caractère limitatif de l'invention.

Des avantages autres que ceux décrits dans la présente demande pourront encore apparaître à l'homme du métier à la lecture des exemples ci-dessous donnés à titre illustratif.

### EXEMPLES

La personne du métier dispose d'une solide littérature de la chimie des oxydes métalliques de type pérovskite de laquelle elle peut tirer parti, en combinaison avec les informations contenues dans ce document, pour des enseignements sur les méthodes de synthèse et la caractérisation des oxydes métalliques de type pérovskite, notamment les oxydes métallique transparents conducteurs de cette famille de pérovskites, lesquels peuvent être exploités pour la mise en oeuvre de la présente invention.

Les références citées dans le présent document fournissent des informations générales utiles sur la préparation et caractérisation des oxydes métalliques de type pérovskite, et leur mise en forme en couches minces.

De plus, la personne du métier pourra se référer à l'enseignement et aux exemples spécifiques fournis dans le présent document, se rapportant à divers exemples de réalisation de couches minces d'oxyde métallique transparent conducteurs de type pérovskite, pour mettre en oeuvre la présente invention dans toute sa portée.

### Exemple 1 : Films minces de SrVO₃

Des films minces de SrVO₃ ont été déposés sur des substrats de verre Eagle XG Corning^{®} de dimension 5 x 5 mm² et 0,5 mm d'épaisseur. Avant traitement, les substrats ont préalablement été nettoyés dans un bain à ultrasons d'acétone puis d'éthanol. Une couche tampon de TiO₂ de 5 nm d'épaisseur a ensuite été déposée par pulvérisation cathodique radiofréquence (RF) à 600°C en pulvérisant une cible métallique de Ti dans un mélange O₂/Ar 10/90% sous une pression de 10⁻² mbar. La puissance injectée sur la cible était égale à 1 W.cm⁻² et la distance cible-substrat était fixée à 4 cm. La couche de SrVO₃ a ensuite été déposée par ablation laser pulsée dans un vide limite de 1x10⁻⁷ mbar en focalisant un laser excimère KrF (λ = 245 nm) sur une cible polycristalline de Sr₂V₂O₇ préparée par réaction standard à l'état solide. La fréquence de répétition du laser était de 3 Hz et la fluence sur la cible était égale à 1,6 J.cm⁻². La pression de travail était égale à 1x10⁻⁶ mbar. La distance cible-substrat était fixée à 5 cm et correspond, dans ces conditions, à un taux de dépôt de 0,09 Å/impulsion.

Afin d'étudier leurs propriétés structurales, l'épaisseur des films de SrVO₃ a été fixée dans un premier temps à 100 nm en ajustant le nombre d'impulsions du laser sur la cible.

L'influence de la température de croissance a été étudiée en chauffant le substrat entre 400 et 600°C au moyen d'une lampe halogène placée sous le porte-substrat.

Afin de vérifier le rôle de la couche tampon de TiO₂, deux films de SrVO₃ de 80 nm d'épaisseur ont été déposés directement sur verre à 400 et 600°C. Dans un deuxième temps, l'épaisseur des films de SrVO₃ a été réduite à 20 nm pour accroitre la transmission optique des films tout en évitant une dégradation importante de la conductivité pour des épaisseurs inférieures **(Ref. 1).**

Les propriétés structurales et les épaisseurs des films déposés ont été contrôlées par diffraction des rayons X (DRX) à l'aide d'un diffractomètre Bruker D8 Discover fonctionnant avec un faisceau monochromatique Cu K_{*α*1} (*λ* = 1,5406 Å).

Les propriétés de transport ont été étudiées entre 5 et 300 K en utilisant la méthode quatre pointes en configuration Van der Pauw au moyen d'un PPMS (Physical Properties Measurement System) de Quantum Design.

Afin de déterminer la concentration et la mobilité des porteurs, des mesures de Hall ont été réalisées dans la même gamme de température en appliquant un champ magnétique variant entre -9 et 9 T perpendiculairement au plan du film. La transmission optique des échantillons a été mesurée dans l'UV-visible- proche infrarouge au moyen d'un spectrophotomètre Perkin-Elmer Lambda 1050 entre 350 nm et 850 nm. Un substrat de verre vierge Eagle XG Corning^{®} a été utilisé comme référence pour l'ensemble des mesures otiques.

### Résultats

### Structure des couches de SrVO₃

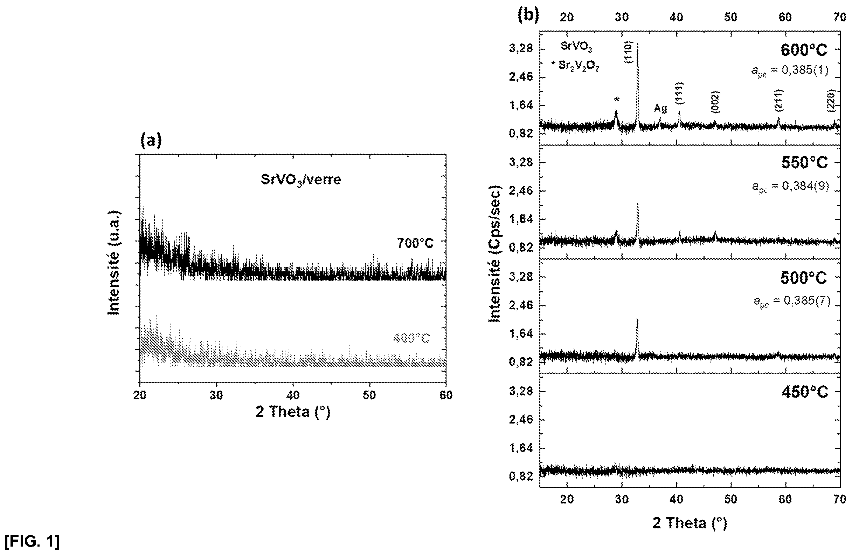

Les diffractogrammes des films minces de SrVO₃ de 80 nm déposés directement sur substrats de verre à 400 et 600°C sont reportés dans la FIG 1a. L'absence de pics de diffraction montre que les couches restent amorphes quelle que soit la température du dépôt. Pour les films de 100 nm d'épaisseur déposés sur TiO₂ entre 450 et 600°C (FIG 1b), les diffractogrammes indiquent que la cristallisation intervient entre 450 et 500°C. A 450°C, aucun pic de diffraction n'est détectable ce qui signifie que la température n'est pas suffisante pour induire la cristallisation du film de SrVO₃ même en présence de la couche tampon de TiO₂. Par ailleurs, l'épaisseur de TiO₂ (5 nm) est trop mince pour provoquer l'apparition de pics de diffraction dans les mesures DRX, mais la croissance cristalline du SrVO₃ dessus indique le caractère cristallin de la couche tampon. A 500°C, les pics caractéristiques de la phase pérovskite cubique SrVO₃ (groupe d'espace *Pm*3̅*m*) **(Ref. 2)** apparaissent avec les réflexions les plus intenses (110) et (211) observées respectivement à 32,81(2) et 58,71(1)°. Par conséquent, le film possède une structure polycristalline induite par le caractère polycristallin de la couche tampon de TiO₂. La structure polycristalline de la couche de SrVO₃ est confirmée à 550°C avec l'apparition d'autres réflexions caractéristiques (111), (002) et (220) observées à 40,51(8), 47,05(8) et 68,93(3)° et qui peuvent être attribuées à la phase SrVO₃. Cependant, l'apparition d'un pic parasite à 28,90(9)° indique la présence d'une impureté attribuée à la phase suroxydée Sr₂V₂O₇. La stabilité de l'intensité de ce pic en comparaison du pic principal (011) de SrVO₃ indique que la phase Sr₂V₂O₇ ne tend pas à se développer davantage avec la température de dépôt. La présence de cette phase entre en compétition avec la croissance de SrVO₃ uniquement à haute température et indique qu'un régime d'oxydation de SrVO₃ intervient probablement en raison de la diffusion de l'oxygène de la couche de TiO₂ vers SrVO₃. Il s'agit d'un processus thermiquement activé suffisant pour former des traces de Sr₂V₂O₇ mais limité compte tenu de faible épaisseur de TiO₂. La phase Sr₂V₂O₇ apparait à partir de 550°C et n'est pas observé à 500°C où seule la phase SrVO₃ est détectée.

Le paramètre de maille cubique *a_{c}* des couches de SrVO₃ polycristallines est compris entre 0,384(9) et 0,385(1) nm et semble être indépendant de la température de croissance des films. Ces valeurs sont similaires à la valeur reportée par Range et al. (*a_{c}* = 3,84(0) nm) pour SrVO₃ massif préparé par réaction à l'état solide **(Ref. 2).** En général, la stabilisation épitaxiale nécessaire à la cristallisation de SrVO₃ sur un substrat monocristallin adapté se traduit systématiquement par l'apparition d'une contrainte épitaxiale et la déformation positive ou négative hors du plan de la maille de SrVO₃ suivant l'écart à la cohérence des paramètres films-substrat **(Ref. 3).** Bien que SrVO₃/TiO₂/verre soit déposé sous forme de couche mince, la structure cristalline de SrVO₃ est ici indépendante de la nature du substrat et le paramètre *a_{c}* similaire à celui mesuré pour le matériau massif. Par ailleurs, la structure polycristalline non texturée de SrVO₃ induite par la couche tampon de TiO₂ favorise un relâchement à courte distance des contraintes résiduelles. L'utilisation d'une couche de germination de TiO₂ pour la croissance de SrVO₃ permet donc avantageusement de limiter les effets habituellement induits par le substrat sur la structure et les propriétés électriques et optiques **(Ref. 3).**

### Transport des couches de SrVO₃

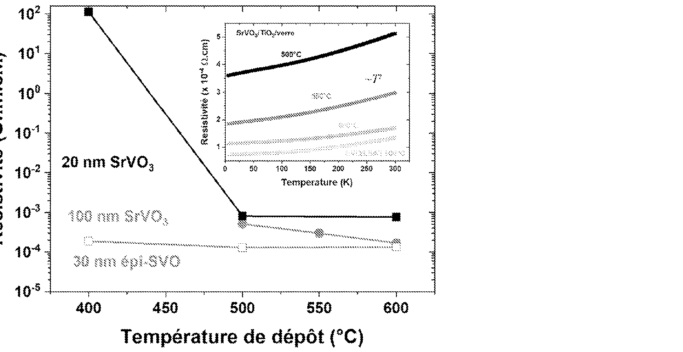

Les résistivités des couches polycristallines mesurées à 300 K sont reportées dans la FIG 2 en fonction de la température de croissance. Les valeurs sont comparées à la résistivité de films monocristallins SrVO₃ de 30 nm d'épaisseur épitaxiés sur monocristal et déposés dans les mêmes conditions de croissance **(Ref. 4).** La résistivité des films de SrVO₃/TiO₂ de 100 nm d'épaisseur est comprise entre 1,68 et 5,12 x 10⁻⁴ Ω.cm. Ces valeurs sont excellentes et sont proches de la résistivité des films monocristallins de 30 nm sur LSAT (1,30 à 1,87 x 10⁻⁴ Ω.cm). Le caractère métallique des couches est confirmé par les courbes en insert qui montrent l'évolution de la résistivité en fonction de la température. Pour l'ensemble de la série, la résistivité suit une dépendance en ~*T*² caractéristique d'un régime de transport dominé par un processus de diffusion électro-électron dans système de type métal corrélé tel que Ca₁₋ₓSrₓVO₃ **(Ref. 5).** Par ailleurs, les courbes montrent clairement une diminution de la résistivité des couches avec l'augmentation de la température de croissance. Cet effet est attribué à l'amélioration de la cristallinité de la couche de SrVO₃ avec la température de croissance en accord avec les analyses DRX (FIG 1b) qui mettent en évidence une augmentation de l'intensité du pic (111) de la phase SrVO₃ avec la température. La présence de la phase parasite suroxydée Sr₂V₂O₇ observée à 500 et 600°C est connue pour posséder un caractère isolant **(Ref. 6)** mais ne semble pas affecter de manière significative le transport des couches de SrVO₃ déposées à ces températures. L'amélioration de la cristallinité et la percolation entre les grains de SrVO₃ sont finalement suffisantes pour observer une baisse de la résistivité avec la température.

La diminution de l'épaisseur des couches de 100 à 20 nm s'accompagne d'une augmentation significative de la résistivité. Par exemple, p passe de 5,13 à 8,08 x 10⁻⁴ Ω.cm à 500°C et de 1,68 à 7,66 x 10⁻⁴ Ω.cm à 600°C. L'effet de l'épaisseur sur la conductivité a été largement observé et étudié dans la littérature pour des couches de SrVO₃ monocristallines. Il est admis que l'augmentation de *ρ* avec la diminution de l'épaisseur est attribuée à une modification du régime de conduction qui induit une transition isolante au-dessous d'une épaisseur seuil **(Refs. 7, 8).** De même, la comparaison de la résistivité des films polycristallins SrVO₃/TiO₂ de 20 nm avec les films de SrVO₃ d'épaisseur similaire (30 nm) épitaxiés sur un substrat LSAT (aluminate de lanthane - tantalate d'aluminium strontium) se traduit par une augmentation de *ρ* mais qui est due dans ce cas, à l'incorporation de nombreux joints de grains dans la microstructure de la couche SrVO₃ et la diminution de la mobilité des porteurs. Par ailleurs, la résistivité du film déposé sur TiO₂/verre à 400°C qui est égale *à ρ* = 122 Ω.cm confirme le caractère isolant de la structure amorphe du SrVO₃. La couche monocristalline de SrVO₃ déposée sur LSAT dans les mêmes conditions est conductrice ce qui s'explique par le fait que la cristallisation de SrVO₃ stabilisé par LSAT se produit dès 400°C **(Ref. 4).**

Globalement, les résistivités des couches de polycristallines SrVO₃ sur couche tampon TiO₂/verre sont excellentes et répondent largement aux exigences requises pour un TCO polycristallin. Par exemple, la couche SrVO₃ intégrée à basse température (500°C) qui est la plus apte d'un point de vue technologique pour un transfert sur des substrats thermiquement sensibles (verre, silicium...) a donc une résistivité de 8,08 x 10⁻⁴ Ω.cm. Sa résistivité est comparable aux TCO polycristallins conventionnels : ITO (1,5 x 10⁻⁴ Ω.cm **(Ref. 9)),** SnO₂:F (2,2 à 70 x 10⁻⁴ Ω.cm **(Refs. 10, 11)),** ZnO dopé (2,7 à 56,5 x 10⁻⁴ Ω.cm **(Refs. 12, 13))** ou TiO₂ dopé (4,8 à 8,7 x 10⁻⁴ Ω.cm **(Refs. 14, 15)).**

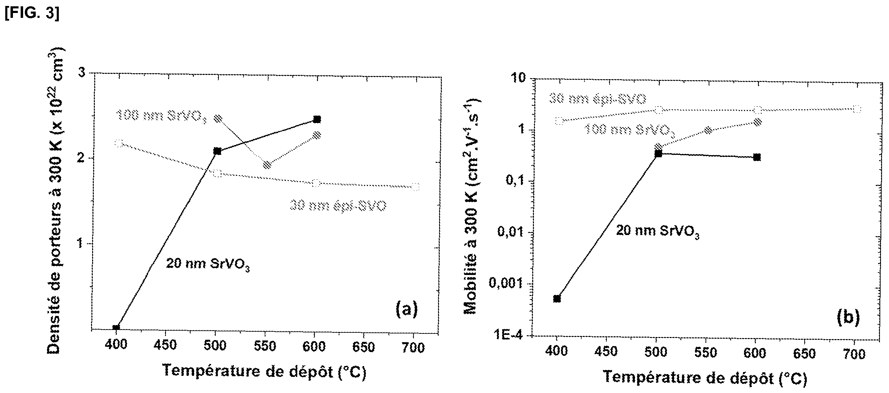

Les métaux corrélés tels que SrVO₃ ont la particularité de posséder une très forte densité de porteurs (-2.2 x 10²² cm⁻³) en comparaison des TCO semiconducteurs à large gap comme l'ITO dont la concentration n'excède pas 3 x 10²¹ cm⁻³ dans les cas les plus favorables **(Ref. 16).** Un nombre de porteurs élevé a l'avantage d'augmenter la conductivité mais également l'inconvénient de diminuer la transparence du matériau en décalant la fréquence plasma de l'infrarouge vers le domaine visible. Dans le cas des vanadates, ce compromis entre conductivité et transparence est réalisé. La densité de porteurs mesurée à 300 K dans les films de SrVO₃ polycristallins sur TiO₂ est comprise entre 1,95 et 2,50 x 10²² cm⁻³ (FIG 3a). Ces valeurs sont idéalement dispersées autour de la valeur théorique (-2.2 x 10²² cm⁻³). Seul le film amorphe SrVO₃/TiO₂/verre déposé à 400°C a une densité de porteurs très fortement inférieure à cette valeur (1,05 x 10²⁰ cm⁻³) qui confirme le comportement isolant mesuré précédemment (FIG 2). Les densités de porteurs des films polycristallins de SrVO₃ sont légèrement supérieures aux valeurs mesurées dans les films monocristallins.

La mobilité des porteurs de charges mesurée à 300 K est reportée dans la FIG 3b en fonction de la température de dépôt. Pour les échantillons d'épaisseurs comparables, la mobilité des films polycristallins est inférieure d'environ un ordre de grandeur à celle mesurée dans les films monocristallins. Par exemple, la mobilité passe de 2,63 à 0,37 cm².V⁻¹.s⁻¹ pour SrVO₃ à 500°C. Contrairement aux films épitaxiés sur monocristal, la présence de joints de grains dans la structure polycristalline limite la délocalisation des électrons dans le réseau cristallin et provoque la diminution de la mobilité des porteurs. Par ailleurs, l'augmentation de la mobilité avec la température de dépôt indique que la qualité structurale des couches s'améliore à plus haute température. Cette observation est cohérente avec les mesures de DRX qui montrent une augmentation de la cristallinité de SrVO₃ entre 500 et 600°C (FIG 1b). Seul l'échantillon amorphe SrVO₃/TiO₂ déposé 400°C possède comme attendu, une mobilité bien en-dessous des exigences attendues pour un TCO.

### Transmission optique des couches de SrVO₃

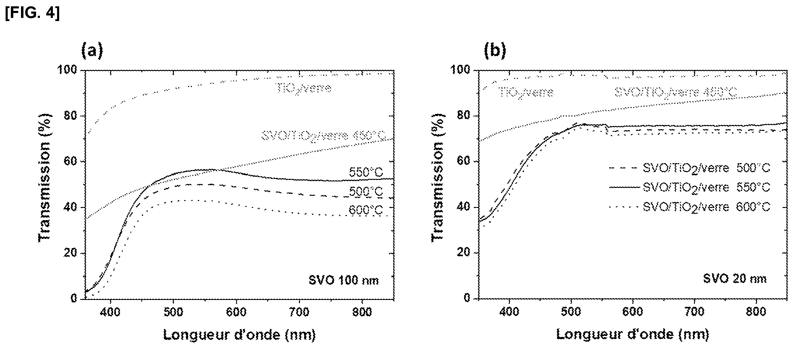

Les spectres de transmission des films de SrVO₃/TiO₂/verre et d'un substrat non revêtu TiO₂/verre ont été mesurés par spectrophotométrie UV-Visible-NIR entre 350 et 850 nm. Les spectres sont reportés dans FIGS 4a et 4b. L'échantillon de TiO₂/verre possède une transmission supérieure à 80 % dans la totalité de la gamme du visible ce qui a peu d'influence sur la transmission globale des échantillons une fois revêtu par SrVO₃. Les films SrVO₃/TiO₂/verre de 100 nm présentent une transmission comprise entre 35 % et 50 % (FIG 4a). Il est intéressant de noter que le film déposé à 600°C est le moins transparent et que la transmission est maximale pour le film déposé à 500°C. La diminution de l'épaisseur de la couche de SrVO₃ à 20 nm (FIG 4b) se traduit par une augmentation importante de la transmission qui atteint alors un plateau situé à 75% entre 450 et 850 nm. La transmission ne dépend plus de la température de croissance de la couche. La transparence des couches moins épaisses devient dans ce cas comparable aux valeurs de transmission typiquement mesurées pour les TCO polycristallins conventionnels (In₂O₃:Sn, SnO₂:F, ZnO:Al...) et située autour de 80 % **(Ref. 17).**

Afin d'estimer les performances d'un TCO en considérant à la fois son comportement conducteur et transparent, il est utile de calculer le facteur de mérite *Φ*_{TC} = *T*¹⁰/*R*_{carré} où *T* est la transmission prise au centre du spectre visible à 550 nm et R_{carré} est la résistance par carré de la couche **(Ref. 18).** Le facteur de mérite des films est tracé en fonction de l'épaisseur (FIG 5) et comparé à différentes valeurs reportées dans la littérature pour SVO monocristallins **(Ref.** 1) et d'autres TCO standards.

Le facteur de mérite des films de SrVO₃/TiO₂/verre de 100 nm d'épaisseur (carrés noirs, FIG 5) est comparable à celui d'un ITO polycristallin déposé sur verre ou sur un substrat flexible comme le poly-téréphtalate d'éthylène (PET). Malgré une transmission inférieure à 60% (FIG 4a), leur excellente conductivité permet d'atteindre un facteur de mérite intéressant. Par exemple, *Φ*_{TC} = 5,54x10⁻⁴ Ω⁻¹ pour la couche déposée à 550°C, ce qui rivalise avec les poly-ITO sur verre (carrés gris). Le facteur de mérite des couches déposées à 500 et 600°C est nettement inférieur car la diminution de la transmission de seulement 10 à 15 % pour ces deux échantillons est amplifiée par l'exposant *T*¹⁰ dans le calcul de *Φ*_{TC}. Les films de 20 nm de SrVO₃/TiO₂/verre ont un *Φ*_{TC} environ égal à 5,54x10⁻⁴ Ω⁻¹ (cercles noirs) ce qui est inférieur d'un ordre de grandeur aux films monocristallins épitaxiés (1,56x10⁻³ Ω⁻¹ **(Ref. 1))** mais reste comparable aux couches polycristallines de TCO conventionnels. Ceci s'explique par la structure polycristalline des couches de SrVO₃ sur TiO₂. Comme il a été démontré précédemment, la présence de joints de grains qui s'oppose à la délocalisation électronique s'accompagne d'une baisse significative de la mobilité des porteurs par rapport à la mobilité dans les couches monocristallines (FIG 3b). Ce comportement est évidemment observé de façon identique entre les couches poly-ITO (carrés gris) et epi-ITO (triangles gris).

Il a été démontré à travers les Exemples ci-dessus qu'une couche tampon polycristalline de faible épaisseur (5 nm) composée de l'oxyde binaire métallique TiO₂ est capable d'induire la cristallisation de la structure pérovskite de SVO. On observe que le TiO₂ cristallise sur des substrats amorphes comme le verre même à basse température et possède une transmission supérieure à 80 % dans le spectre visible qui n'entrave pas les propriétés optiques des vanadates. Cette couche tampon est relativement simple à mettre en oeuvre avec les techniques de dépôt de couches minces habituellement utilisées dans l'industrie et représente par conséquent un procédé au coût limité.

Dans les Exemples, il a été montré que les films polycristallins de SVO (vanadate de strontium) stabilisés grâce à une couche tampon de TiO₂ déposée sur verre ont des propriétés optiques et électriques comparables à celles de l'ITO. En considérant l'absence d'indium qui permet de diviser par 5 le coût du matériau tout en conservant les propriétés attendues pour un TCO standard, la croissance de SVO sur verre permet donc d'envisager concrètement les applications potentielles pour ce nouveaux TCO.

### Conclusion - Exemple 1

En l'absence d'une couche tampon, la cristallisation spontanée de SrVO₃ sur verre par ablation laser pulsée est impossible. Par ailleurs, on sait que contrairement à l'ITO amorphe, les couches de SrVO₃ doivent nécessairement être cristallisées pour être conductrices. L'utilisation d'une couche tampon polycristalline de l'ordre de 5 nm d'épaisseur composée de l'oxyde binaire métallique TiO₂ induit la cristallisation de SrVO₃ dès 500°C. Cette couche tampon est facile à déposer à basse température sur des substrats amorphes comme le verre à l'aide des techniques de dépôts standards (PLD, PVD, ALD...). Les couches de SrVO₃ synthétisées sont polycristallines et possèdent d'excellentes propriétés conductrices comparables aux TCO polycristallins conventionnels. Par exemple, une résistivité de 8,08 x 10⁻⁴ Ω.cm est obtenue pour 20 nm de SrVO₃ déposé à 500°C. A l'inverse des couches monocristallines, le transport dans les couches polycrystallines n'est pas influencé par la nature du substrat mais uniquement par la présence des joints de grains et par les conditions de dépôt. L'intégration et la reproductibilité des couches synthétisées est donc industriellement plus simple à mettre en oeuvre. Enfin, la transmission des couches de 20 nm (~ 75 %) est également excellente et comparable à la transparence des TCO conventionnels comme l'ITO ou le ZnO dopé (~ 80 %). En conclusion, il a été démontré à travers les exemples que l'utilisation d'une couche tampon de TiO₂ induit la croissance de SrVO₃ à température modérée sur des substrats inadaptés comme le verre ou le silicium qui sont pourtant impératifs pour le type d'applications visées (dalles conductrices, photovoltaïque, blindages...). Le verrou technologique lié à leur intégration est ainsi levé et permettra dans le futur, de démocratiser les vanadates comme nouveaux TCO. En résumé, la présente invention permet de résoudre une problématique importante de certains oxydes métalliques de types pérovskite, notamment les TCO de vanadates. En effet, la cristallisation des TCO de vanadates sur des substrats inadaptés comme le verre étant un obstacle majeur, l'utilisation d'une couche de germination intermédiaire est une solution de premier plan qui permet d'envisager sérieusement des applications technologiques.

### Exemple 2 : Films minces de CaVO₃ et SrTiO₃

Les films minces de CaVO₃ et SrTiO₃ sont déposés sur des substrats de verre Corning Eagle XG (Codex international) de dimension 5 x 5 mm² et 0,5 mm d'épaisseur. Les substrats sont nettoyés suivant le protocole standard décrit dans l'exemple 1 (bain à ultrasons d'acétone puis d'éthanol).

### Dépôt de la couche tampon TiO₂ :

Après le nettoyage des substrats, ils sont introduits dans l'enceinte de dépôt par ablation laser pulsé (PLD). Une fois un vide de l'ordre de 10⁻⁷ mbar atteint, les substrats sont chauffés à une température de 600°C. Une couche tampon de TiO₂ d'une épaisseur de 10 nm a été déposée dans une pression partielle d'oxygène de 10⁻² mbar à l'aide d'un laser eximère KrF (λ = 248 nm). L'énergie du laser est fixée à 200 mJ ce qui correspond à une fluence d'environ 2 J.cm⁻², la fréquence des impulsions laser a été fixée à 5 Hz et la distance cible-substrat a été fixée à 5 cm.

### Dépôt des couches minces de CaVO₃ et SrTiO₃ :

Après le dépôt de la couche tampon de TiO₂, les couches de CaVO₃ et SrTiO₃ ont été déposées dans les mêmes conditions de dépôt du SVO décrites dans l'exemple 1, sauf la fréquence des impulsions laser a été fixée à 5 Hz dans le cas du CVO.

### Caractérisations :

L'analyse structurale et le calcul de l'épaisseur des films ont été déterminés par diffraction et réflectométrie des rayons X (DRX et RRX) à l'aide d'un diffractomètre Bruker D8 Discover fonctionnant avec un faisceau monochromatique Cu K_{*α*1} (λ = 1,5406 Å). La résistivité des films à 300 K a été déterminée en utilisant la méthode quatre pointes par le biais d'un Sourcemètre Keithley 2450. La transmission optique des échantillons est mesurée dans l'UV-visible - proche infrarouge suivant le même protocole que celui décrit dans l'exemple 1.

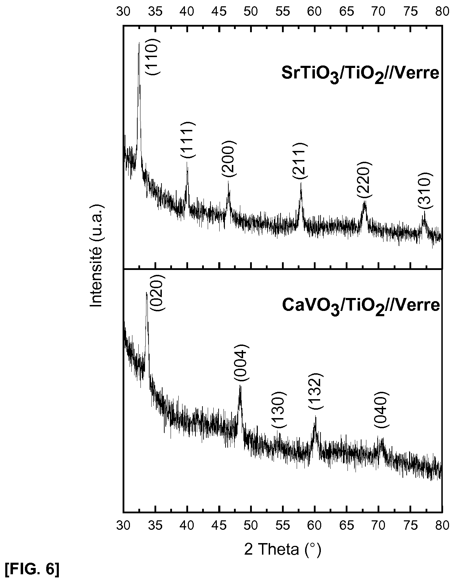

La figure 6 représente les diagrammes des rayons X en configuration incidence rasante des films de CaVO₃ et SrTiO₃ déposés sur une couche tampon de TiO₂. Les épaisseurs de la couche tampon TiO₂ et des films de CaVO₃ et SrTiO₃ ont été fixées à environ 10 nm et 30 nm, respectivement. L'épaisseur de la couche tampon a été optimisée pour qu'elle soit suffisante pour induire la croissance polycristalline des films de SVO.

Les diagrammes montrent clairement une croissance polycristalline des deux films de CVO et STO, sans autre phase parasitaire. Le caractère polycristallin des films se manifeste par l'apparition de toutes les réflexions caractéristiques du CVO et STO, ayant également le bon rapport d'intensité entre les pics. Pour les films de CVO, les pics de diffraction caractéristiques apparaissent à 2θ= 33.699°, 48.327°, 54.331°, 60.050° et 70.549° qui sont associés aux plans (020), (004), (130), (132) et (040) de la phase pérovskite orthorhombique CaVO₃ (groupe d'espace *Pnma*)*.* Pour les films de STO, les pics de diffraction apparaissent à 2θ=32.450°, 40.031°, 46.528°, 57.881°, 67.861°, et 77.160° associés aux plans (110), (111), (200), (211), (220) et (310) de la phase pérovskite cubique SrTiO₃ (groupe d'espace *Pm-3m*)*.* Le film de CVO a un paramètre de maille *a_{pc}*=0.375(7) nm proche à celui du matériau massif *a_{pc}*=0.377(0) nm **(Ref. 1),** et le film de STO a un paramètre de maille a=0.389(8) nm qui est semblable à celui de STO massif a= 0.390(1) nm **(Ref. 36).**

La croissance polycristalline des films de CVO et STO a été favorisée par la présence de la couche tampon de TiO₂ qui se cristallise facilement sur des substrats amorphes et devient un site de germination et de croissance des films de CVO et STO. Les présents résultats confirment le potentiel de l'utilisation de TiO₂ comme couche tampon pour la croissance des oxydes métalliques conducteurs et transparents de structure pérovskite sur des substrats non adaptés ou non cristallins. STO étant également utilisé largement en tant que substrat pour la croissance cristalline des oxydes pérovskites, la démonstration de la croissance cristalline sur la couche tampon permet alors de prévoir la croissance à succès d'une aussi large gamme sur la couche tampon revêtu d'une couche de STO.

### Propriétés électriques des films de CaVO₃ et SrTiO₃ :

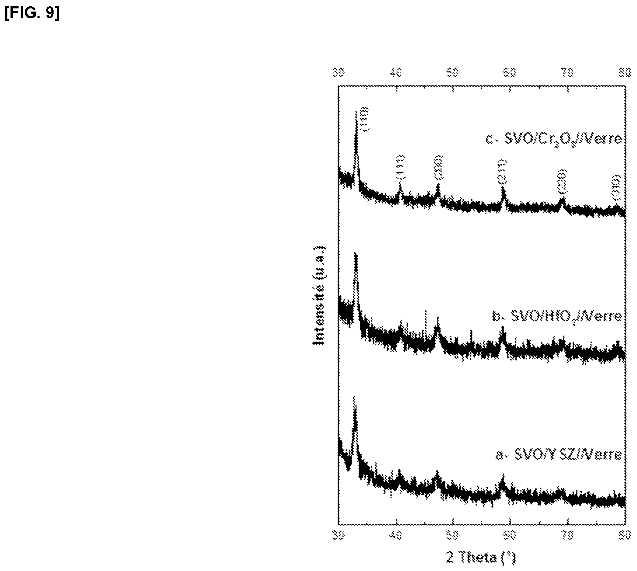

La résistivité des films polycristallins de CVO à 300 K est comprise entre 798 µΩ.cm et 1410 µΩ.cm qui restent des valeurs très bonnes en comparaison avec le CVO monocristallin, montrant une résistivité de 384 µΩ.cm **(Ref. 1)** et en comparaison également avec les autres TCOs polycristallins cités en référence à la figure 9. L'origine de l'augmentation de la résistivité dans les films polycristallins est due la présence des joints de grains comme il a déjà été expliqué dans l'exemple 1 dans le cas des films de SVO. La résistivité des films de STO est *ρ*=85.3 mΩ.cm, ce qui reste assez large pour un TCO. Néanmoins, les propriétés électriques du STO dépendent très fortement de la stœchiométrie en oxygène **(Ref. 37),** ainsi il est possible qu'un échange d'atome d'oxygène entre le film de STO et la couche tampon a eu lieu, ce qui explique cette valeur de résistivité. Il pourrait s'avérer nécessaire d'utiliser un des autres matériaux listés à la suite dans l'exemple 4 en tant que couche tampon pour éviter cet échange d'oxygène et ainsi d'obtenir des valeurs de résistivité plus faibles.

### Propriétés optiques des films de CaVO₃ et SrTiO₃ :

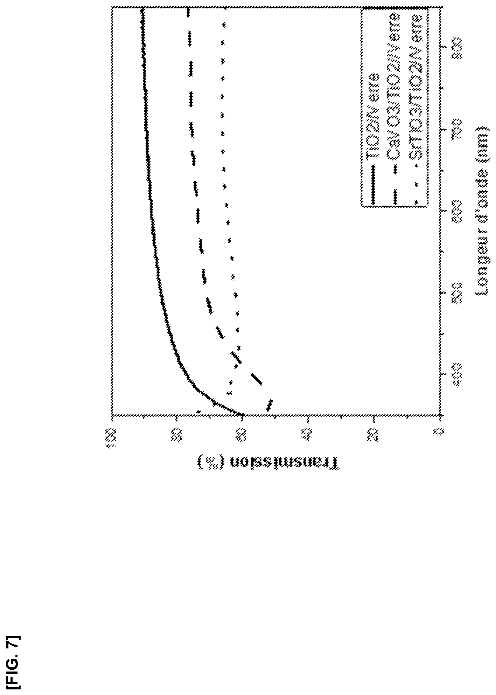

La figure 7 représente les spectres de la transmission optique des films de CaVO₃/TiO₂/verre, SrTiO₃/TiO₂/verre et d'un substrat revêtu par une couche de TiO₂ utilisé comme référence. Les spectres ont été mesurés par spectrophotométrie UV-Visible-NIR entre 350 et 850 nm. Le spectre de l'échantillon référence montre une transmission optique proche de 90% dans toute la gamme du spectre visible, donc l'influence sur la transmission optique des films de CaVO₃ et SrTiO₃ déposés par par-dessus est négligeable. Le film de CaVO₃/TiO₂/verre a une transmission optique de 72% à λ=520 nm, ce qui est similaire à la transmission des films de SVO montrés dans l'exemple 1 avec la même épaisseur. Cette valeur de la transmission optique est largement suffisante pour l'utilisation de CVO polycristallin comme TCO. Les films de SrTiO₃ présentent une transmission optique de 63% à λ=520 nm, ce qui reste une valeur acceptable pour un TCO. Etant donné que le comportement électrique et optique du STO sont corrélés et que son comportement électrique dépend directement de la stœchiométrie en oxygène dans le film, il est donc possible d'augmenter la transmittance des films de STO en contrôlant mieux sa stœchiométrie.

### Exemple 3 : Films minces de BaTiO₃

Le BaTiO₃ est un oxyde de structure pérovskite très étudié pour ses propriétés de ferroélectricité. Il est très attractif pour des applications en microélectronique comme mémoires non-volatiles ferroélectriques. La croissance directe de couches minces du BaTiO₃ sur des substrats amorphes comme le verre n'a jamais été reporté dans la littérature. Dans cet exemple, nous démontrons qu'en utilisant la stratégie de la couche tampon d'oxyde métallique binaire, il est possible de déposer des couches polycristallines de BaTiO₃ sur des substrats amorphes :
Les films minces de BaTiO₃ (BTO) ont été déposés sur des substrats de verre Corning Eagle XG (Codex international) de dimension 5 x 5 mm² et 0,5 mm d'épaisseur. Les substrats sont nettoyés suivant le protocole décrit dans le cadre de l'exemple 1. Une couche tampon de TiO₂ a été déposée avant le dépôt des films de BTO suivant le protocole décrit dans le cadre de l'exemple 2.

Après le dépôt de la couche tampon de TiO₂, les films de BTO ont été déposés à une température de 645°C et pression partielle de 5.1 x 10⁻⁴ mbar d'un mélange gazeux de 0.1 % d'ozone (O₃) et 99.9 % d'O₂. Les films sont refroidis dans une pression partielle de 5 x 10⁻³ mbar.

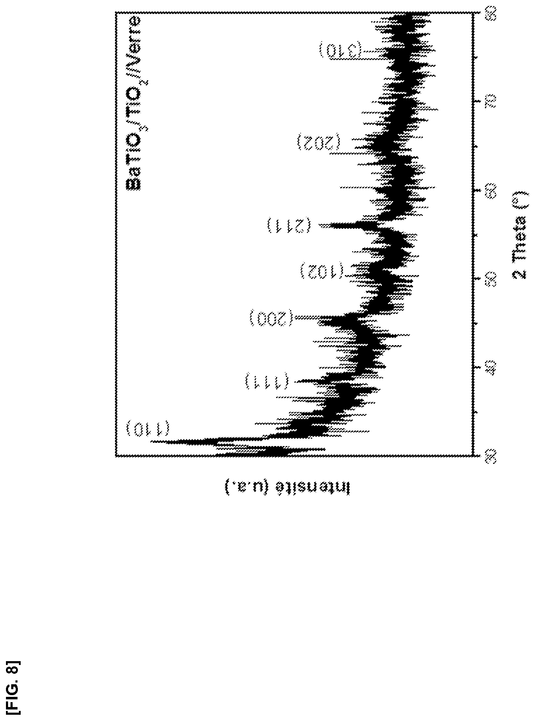

Résultats - Exemple 4 : La figure 8 représente le diagramme de diffraction des rayons x des films minces de BaTiO₃. L'épaisseur des films a été déterminée par réflectométrie des rayons X de situer à environ 30 nm. L'apparition des différents pics caractéristiques de la phase pérovskite tétragonale BaTiO₃ (groupe d'espace *P4mm)* dans le diagramme de diffraction indique le caractère polycristallin des couches. Le film a un paramètre de mail a*_{pc}*=0.399(9) nm, qui est égale à celui du matériau massif de 0.399(4) nm.

### Exemple 4 : Utilisation de différentes couches tampons d'oxyde métallique binaire pour la croissance des films d'oxydes pérovskite

Dans cet exemple nous démontrons le potentiel de l'utilisation d'autres oxydes binaires que celle mis en oeuvre dans les exemples qui précèdent en tant que couche tampon, et qui permettent également la croissance polycristalline des oxydes de structure pérovskite.

L'intérêt d'avoir une large gamme de matériau d'oxyde binaire pouvant être utilisés comme couche tampon est de pouvoir choisir la couche tampon la plus adaptée à la croissance de chaque matériau en termes de désaccord de paramètre de maille ou de compatibilité chimique. Ceci permet d'optimiser les propriétés fonctionnelles des oxydes pérovskites.

Les films minces de SrVO₃ ont été déposés sur des substrats de verre Corning Eagle XG (Codex international) de dimension 5 x 5 mm² et 0,5 mm d'épaisseur. Les substrats sont nettoyés suivant le protocole décrit dans les exemples précédents. Des couches tampons d'YSZ (10% Y₂O₃, 90% ZrO₂), HfO₂ et Cr₂O₃ ont été déposées par ablation laser pulsé (PLD) dans les mêmes conditions de croissance de TiO₂ que celles décrites dans l'exemple 2.

Les épaisseurs de la couche tampon (YSZ, HfO₂ ou Cr₂O₃) et du SrVO₃ ont été fixées à environ 10 nm et 30 nm respectivement afin d'éviter tout effet lié à l'épaisseur de la couche tampon sur les propriétés structurales, électriques et optiques des couches de SrVO₃ et permettre de comparer uniquement les propriétés des films de SVO liés à la nature de la couche tampon utilisée.

### Propriétés structurales des films de SrVO₃

La figure 9 représente les diagrammes de diffraction des rayons X en configuration incidence rasante des films de SrVO₃ déposés sur les différentes couches tampons ; YSZ, HfO₂ et Cr₂O₃. Les trois diagrammes montrent un caractère polycristallin des couches de SVO quelle que soit la couche tampon utilisée, par l'apparition de tous les pics de diffraction associés aux plans (110), (111), (200), (211), (220) et (310) de la phase pérovskite cubique SrVO₃. Les diagrammes montrent également la croissance de la phase pérovskite SVO pure et aucune phase secondaire n'est détectable, indiquant que les trois matériaux utilisés en tant que couche tampon sont stables chimiquement. Ainsi, aucune réaction interfaciale ou phénomène de diffusion atomique n'a eu lieu entre le film de SVO et les couches tampons. A partir des diagrammes des rayons X, nous observons que les trois couches tampons permettent d'obtenir des films de SrVO₃ de bonne qualité cristalline.

En ce qui concerne les paramètres de maille des films de SVO, il semble que le paramètre de maille varie très légèrement en fonction de la couche tampon utilisée, les films de SVO déposés sur une couche tampon d'YSZ ont un paramètre de maille a*_{pc}*=0.384(1) nm, sur HfO₂ a*_{pc}*=0.383(5) nm et sur Cr₂O₃ a*_{pc}*=0.383(1) nm. Cette légère variation du paramètre de maille pourrait être expliquée par la présence des lacunes d'oxygène dans les films de SVO avec une concentration différente et qui dépend de la nature du métal constituant la couche tampon et son affinité envers l'oxygène.

### Propriétés électriques des films de SrVO₃ :

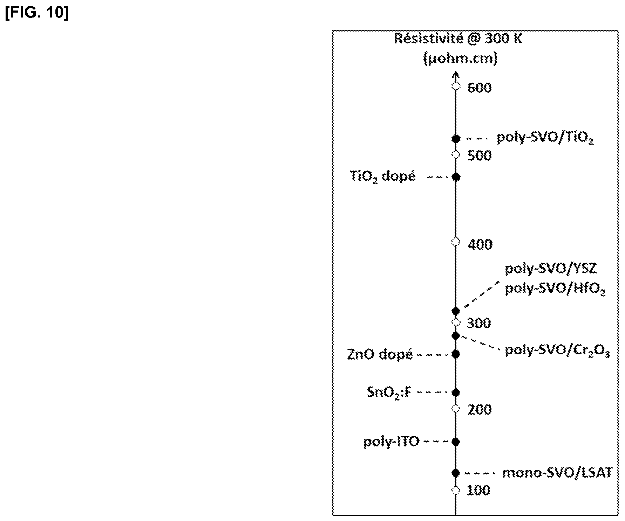

La figure 10 représente une comparaison des mesures de la résistivité à 300 K des films de SVO déposés sur les différentes couches tampons (TiO₂, YSZ, HfO₂ et Cr₂O₃) avec les données de la littérature des oxydes transparents conducteurs utilisés comme TCO. L'épaisseur des films de SVO a été fixée à environ 30 nm sur toutes les couches tampons, et elle est comparable à l'épaisseur des autres TCO cités dans cette comparaison (poly-ITO, SnO₂ : F, ZnO dopé et TiO₂ dopé) **(Ref. 9-15).**

La résistivité des films polycristallins de SVO est comprise entre 294 µΩ.cm et 526 µΩ.cm et semble dépendante de la nature de la couche tampon utilisée. Ces valeurs sont très proches des valeurs des films de SVO monocristallins qui sont de l'ordre de 150 µΩ.cm **(Ref. 3).** Il est à noter que quelques soit le matériau utilisée en tant que couche tampon, la valeur de la résistivité des films de SVO est comparable à celle de l'ITO. Les films déposés sur une couche tampon de Cr₂O₃ ont la résistivité la plus faible de 294 µΩ.cm. Cette faible résistivité revient probablement à la présence du Cr qui joue le rôle d'un absorbeur d'oxygène de la couche de SVO et permet d'éviter la formation d'autre phase suroxydée qui pourrait diminuer les performances du SVO.

La croissance des films de SVO polycristallins sur les différentes couches tampons d'oxyde binaire YSZ, HfO₂ et Cr₂O₃ qui ont d'excellentes propriétés structurales, et électriques, confirme les résultats déjà obtenus sur TiO₂ et ouvre de nouvelles voies vers l'intégration des oxydes pérovskite dans des dispositifs industriels qui était jusqu'à présent un défi.

### Propriétés optiques des films de SrVO₃ :

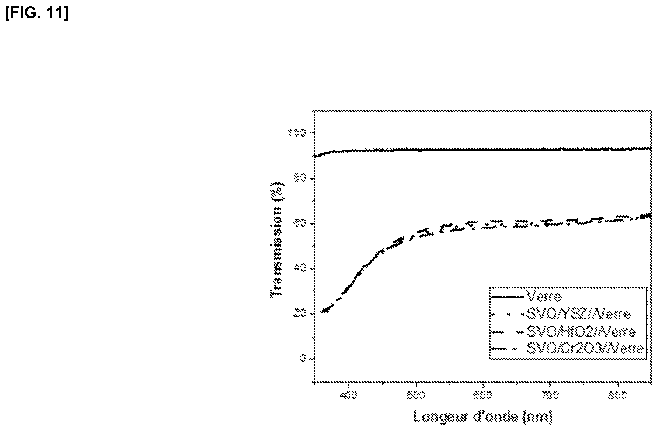

La figure 11 représente les spectres de la transmission optique des films de SVO déposés sur les trois couches tampons SrVO₃/YSZ/Verre, SrVO₃/HfO₂/Verre et SrVO₃/Cr₂O₃/Verre et d'un substrat en verre nu utilisé comme référence. Les spectres ont été mesurés par spectrophotométrie UV-Visible-NIR entre 350 et 850 nm. Le spectre de l'échantillon référence montre une transmission optique supérieur à 90% dans toute la gamme du spectre visible, donc son influence sur la transmission des films de SVO déposés par-dessus est considérée comme négligeable. Les films de SVO déposés sur les trois couches tampons YSZ, HfO₂ et Cr₂O₃ montrent une transmission optique de 58%. Cette différence de transmission par rapport aux échantillons montrés dans l'exemple 1 peut s'expliquer par une contribution des couches tampons.

**Commentaires et analyses** : Dans les exemples 1 à 4, il est montré qu'il est possible de déposer des couches polycristallines de SrVO₃ qui ont de bonnes propriétés structurales, électriques et optiques sur des substrats amorphes en verre en utilisant l'invention de la couche tampon d'oxyde binaire tel que le TiO₂, YSZ, HfO₂ et Cr₂O₃. Il a été remarqué qu'il y a une dégradation des propriétés fonctionnelles des films de SVO avec le temps : formation d'une phase suroxydée de Sr₃V₂O₈ et augmentation de la résistivité des films **(Ref. 38-40).** Avant l'intégration des films de SVO dans des dispositifs industriels comme les cellules photovoltaïques ou des écrans plats, il est primordial de s'assurer de la durabilité des propriétés de SVO.

### Exemple 5 : Couches protectrices

Dans cet exemple nous montrons l'efficacité de l'utilisation d'une couche de protection à base d'oxyde métallique qui permettra de protéger les films de SVO contre la dégradation.

Des mesures de vieillissement accéléré ont été réalisées sur cinq échantillons de SVO à l'aide d'une plaque chauffante, la température de chauffage a été fixée à 250°C. L'évolution de la résistivité des films a été suivi *in-situ* à l'aide d'une tête de mesure quatre pointes couplée à un Sourcemeter Keithley 2450 qui permet d'enregistrer la variation de la résistivité en fonction du temps. Le film SVO a été déposé sur verre avec une couche tampon de TiO₂, comme décrit dans l'exemple 1. Les matériaux utilisés comme couche protectrice sont l'Al₂O₃, LaAlO₃ (LAO) et le TiO₂. Ils ont été déposés d'une manière subséquente sur le film de SVO, avec la même technique de dépôt. Concernant le TiO₂, il a été déposé dans deux conditions différentes : sous vide et avec une pression partielle en oxygène de 10⁻² mbar qu'on va les désigner dans la suite de cet exemple par TiO₂-vide et TiO₂-O respectivement. Les autres matériaux ont été déposé sous vide, la température de dépôt a été fixée à 100°C pour tous les films afin d'obtenir des films amorphes. L'épaisseur de la couche protectrice a été fixée à environ 7 nm.

### Résultats :

### Mesures de vieillissement accéléré :

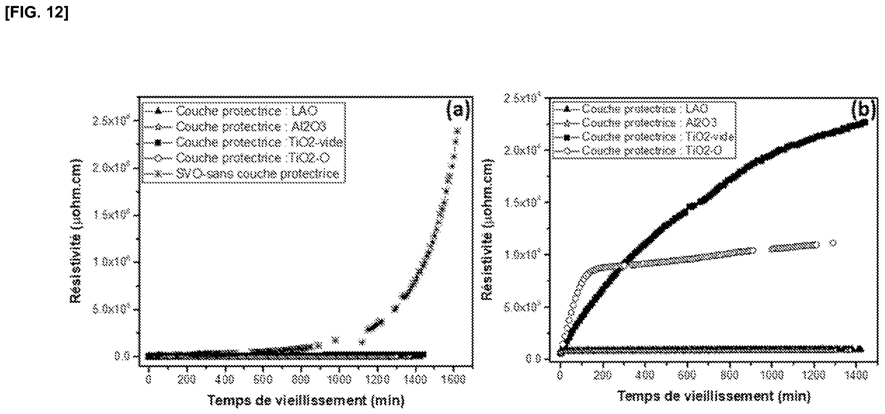

La figure 12-a représente les mesures de vieillissement accéléré réalisé à une température de 250°C et pendant 24h sur des films minces de SVO sans couche protectrice et avec couche protectrice de TiO₂ (déposé sous vide et avec pression partielle d'oxygène), LAO et Al₂O₃. La forte augmentation de la résistivité en fonction du temps de la couche de SVO sans couche protectrice montre son rapide vieillissement, aboutissant dans un comportement isolant à la fin du test. La figure 12-a montre que la résistivité des films de SVO avec une couche protectrice varie beaucoup plus lentement. Nous avons tracé dans la figure 12-b l'évolution de la résistivité sans présenter la courbe du film de SVO sans couche protectrice afin de rendre visible les différences de comportement entre les différentes couches protectrices. Les quatre couches protectrices semblent être efficaces et protègent bien la phase conductrice du SVO. Les films de LAO et Al₂O₃ présentent une variation de résistivité très faible, et ainsi les meilleures propriétés de protection. Dans le cas du Al₂O₃, le rapport entre la résistivité finale après 24h de vieillissement et la résistivité initiale est de 1.48, pour la couche de LAO ce rapport est de 1.54, pour le TiO₂-O il est de 20, pour le TiO₂-vide ce rapport vaut 35. Pour le film de SVO sans couche protectrice, il est de 1.08x10⁴. Le pouvoir de protection de chaque matériau a un lien direct avec son affinité avec l'oxygène qui semble être la cause principale de la dégradation des films de SVO, la protection pourrait également être acquise si la couche protectrice joue le rôle d'une barrière entre le film de SVO et l'oxygène présent dans l'air.

### Propriétés structurales des films de SrVO₃ :

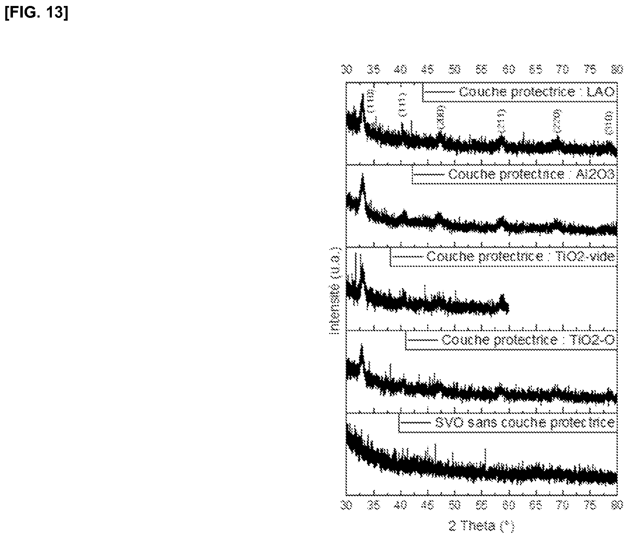

La figure 13 représente les digrammes de diffraction des rayons X des films de SVO sans couche protectrice et avec couche protectrice de TiO₂-O, TiO₂-vide, Al₂O₃ et LAO. Les cinq films ont subi un vieillissement accéléré à une température de 250°C durant 24h. Le diagramme de diffraction du film de SVO sans couche protectrice ne montre aucun pic de diffraction, ce qui indique que le film est devenu amorphe ou contient des domaines cristallins trop petits pour être détectés par la diffraction des rayons X. Concernant les films de SVO avec couche protectrice, les pics de diffraction sont toujours présents quel que soit la couche protectrice, ce qui révèle que les films de SVO protégés gardent leur structure polycristalline. Ils ne sont pas dégradés durant le test de vieillissement. Ce résultat est en bon accord avec les mesures électriques qui montrent que le SVO protégé garde son comportement métallique.

### REFERENCES

1. L. Zhang, Y. Zhou, L. Guo, W. Zhao, A. Barnes, H.-T. Zhang, C. Eaton, Y. Zheng, M. Brahlek, H. F. Haneef, N. J. Podraza, M. H. W. Chan, V. Gopalan, K. M. Rabe, R. Engel-Herbert, Nat. Mater. 15, 204 (2016).
2. K.-J. Range, F. Rau, U. Klement, Z. Für Naturforschung B 46, 1315 (1991).
3. A. Boileau, A. Cheikh, A. Fouchet, A. David, C. Labbé, P. Marie, F. Gourbilleau, U. Lüders, Adv. Optical Mater. 1801516 (2019).
4. A. Boileau, A. Cheikh, A. Fouchet, A. David, R. Escobar-Galindo, C. Labbé, P. Marie, F. Gourbilleau, U. Lüders, Appl. Phys. Lett. 112, 021905 (2018).
5. I. H. Inoue, O. Goto, H. Makino, N. E. Hussey, M. Ishikawa, Phys. Rev. B 58, 4372 (1998).
6. J. Macías, A. A. Yaremchenko, J. R. Frade, Journal of Alloys and Compounds 601, 186-194 (2014).
7. D. H. Kim, D.-W. Kim, B. S. Kang, T. W. Noh, D. R. Lee, K.-B. Lee, S. J. Lee, Solid State Communications 114, 473-476 (2000).
8. A. Fouchet, M. Allain, B. Bérini, E. Popova, P.-E. Janolin, N. Guiblin, E. Chikoidze, J. Scola, D. Hrabovsky, Y. Dumont, N. Keller, Mater. Sci. Eng. B 212, 7 (2016).
9. U. Betz, M. Kharrazi Olsson, J. Marthy, M. F. Escola' and F. Atamny, Surf. Coat. Technol. 200, 5751-5759 (2006).
10. D. S. Bhachu, M. R. Waugh, K. Zeissler, W. R. Branford and I. P. Parkin, Chem. Eur. J. 17, 11613-11621 (2011).
11. R. Mientus and K. Ellmer, Surf. Coat. Technol. 98, 1267-1271 (1998).
12. V. Assunção, E. Fortunato, A. Marques, A. Gonçalves, I. Ferreira, H. Águas and R. Martins, Thin Solid Films 442, 102-106 (2003).
13. L.-H. Wong and Y.-S. Lai, Thin Solid Films 583, 205-211 (2015).
14. T. Hitosugi, A. Ueda, S. Nakao, N. Yamada, Y. Furubayashi, Y. Hirose, T. Shimada and T. Hasegawa, Appl. Phys. Lett. 90, 212106 (2007).
15. B.-B. Wu, F.-M. Pan and Y.-E. Yang, Chin. Phys. Lett. 28, 118102 (2011).
16. A. J. Freeman, K. R. Poeppelmeier, T. O. Mason, R. P. H. Chang, and T. J. Marks, MRS Bull. 25, 45 (2000).
17. S. C. Dixon, D. O. Scanlon, C. J. Carmalt, and I. P. Parkin, J. Mater. Chem. C 4, 6946 (2016).
18. G. Haacke, J. Appl. Phys. 47, 4086-4089 (1976).
19. B. Bérini, V. Demange, M. Bouttemy, E. Popova, N. Keller, Y. Dumont, A. Fouchet, Adv. Mater. Interfaces 3, 1600274 (2016).
20. D. L. Ritums, N. J. Wu, X. Chen, D. Liu, A. Ignatiev, AIP Conf. Proc. 420, 672 (1998).
21. P. W. Yip, K. H. Wong, MRS Online Proc. Libr. Arch. 623 (2000).
22. H. Ohta, M. Orita, M. Hirano and H. Hosono, J. Appl. Phys. 91, 3547-3550 (2002).
23. J. A. Moyer, C. Eaton, R. Engel-Herbert, Adv. Mater. 25, 3578 (2013).
24. K. Ellmer, Nature Photon. 6, 809-817 (2012).
25. F. L. Wong, M. K. Fung, S. W. Tong, C. S. Lee and S. T. Lee, Thin Solid Films, 466, 225-230 (2004).
26. V. Teixeira, H.N. Cui, L. J. Meng, E. Fortunato, R. Martins, Thin Solid Films 420 -421, 70-75 (2002).
27. B. O'Connor, C. Haughn, K.-H. An, K. P. Pipe, and M. Shtein, Appl. Phys. Lett. 93, 223304 (2008).
28. D. R. Sahu, S.-Y. Lin, J.-L. Huang, Applied Surface Science 252, 7509-7514 (2006).
29. J. B. Goodenough, Reports on Progress in Physics 67, 1915 - 1993 (2004).
30. L. Hu, R. Wei, J. Yan, D. Wang, X. Tang, X. Luo, W. Song, J. Dai, X. Zhu, C. Zhang, Y. Sun, Advanced Electronic Materials 4, 1700476 (2018).
31. K. H. L. Zhang, Y. Du, A. Papadogianni, O. Bierwagen, S. Sallis, L. F. J. Piper, M. E. Bowden, V. Shutthanandan, P. V. Sushko, S. A. Chambers, Advanced Materials 27, 5191 - 5195 (2015).
32. O. Y. Gorbenko, S. V. Samoilenkov, I. E. Graboy, A. R. Kaul, Chem. Mater. 14, 4026 - 4043 (2002).
33. D. G. Schlom, L.-Q. Chen, X. Pan, A. Schmehl, M. A. Zurbuchen, Journal of the American Ceramic Society 91, 2429 - 2454 (2008).
34. J. M. D. Coey, M. Viret, S. von Molnar, Advances in Physics 48, 167 - 293 (1999).
35. K. M. Rabe, M. Dawber, C. Lichtensteiger, C. H. Ahn, J.-M. Triscone, Topics Appl. Physics 105, 1 - 30 (2007).
36. Yu. A. Abramov, V.G. Tsirelson, V.E. Zavodnik, S.A. Ivanov, and I. D. Brown, Acta Crystallogr B Struct Sci 51, 942 (1995).
37. J. Ravichandran, W. Siemons, H. Heijmerikx, M. Huijben, A. Majumdar, and R. Ramesh, Chemistry of Materials 22, 3983 (2010).
38. He, H., Yang, Z., Xu, Y. et al. Nano Convergence 7, 32 (2020).
39. A. Sharma, M. Varshney, W. Cheol Lim, H.-J. Shin, J. Pal Singh, S. Ok Won, and K. Hwa Chae, Phys. Chem. Chem. Phys. 19, 6397 (2017).
40. R.C. Germanicus, Y. Bourlier, V. Notot, B. Bérini, V. Demange, M. Berthe, A. Boileau, M. Euchin, Y. Dumont, D. Aureau, M. Fregnaux, B. Grandidier, U. Lüders, A. David, W. Prellier, L. Biadala, and A. Fouchet, Applied Surface Science 510, 145522 (2020).

## Revendications

1. Système conducteur multicouche d'oxydes métalliques comprenant :
i. un substrat transparent amorphe ayant une tenue en température de 500°C ;
ii. une couche d'un oxyde métallique binaire cristallin, déposée sur le substrat (i); et
iii. une couche d'un oxyde métallique conducteur cristallin ayant une structure cristalline de type pérovskite superposée sur la couche d'oxyde métallique binaire (ii);
l'oxyde métallique binaire de la couche (ii) ayant un désaccord de maille local à l'interface oxyde métallique pérovskite/oxyde métallique binaire de moins de 5% par rapport à celui de l'oxyde métallique de la couche (iii) ;
sous réserve que lorsque l'oxyde métallique de type pérovskite de la couche (iii) est un oxyde métallique conducteur transparent cristallin, l'épaisseur de la couche d'oxyde métallique binaire cristallin (ii) est < 20 nm, de préférence < 10 nm, tout préférentiellement 5-7 nm.

2. Système conducteur multicouche selon la revendication 1, dans lequel l'oxyde métallique de type pérovskite de la couche (iii) comprend :
A. un oxyde métallique conducteur transparent cristallin répondant à la formule ABO₃ dans laquelle A est choisi parmi Sr ou Ca éventuellement dopé avec La ou un autre élément des groupes des lanthanides, et B est choisi parmi V, Cr, Ti ou Mo ;
B. une manganite à magnétorésistance colossale de structure pérovskite répondant à la formule Ln₍₁₋ₓ₎AₓMnO₃ dans laquelle Ln représente un atome de terre rare (La, Pr, Nd, etc..), A est choisi parmi les atomes alcalinoterreux (Ba, Sr, Ca, etc...) et x représente le taux de dopage de l'alcalinoterreux; ou
C. un oxyde métallique ferroélectrique de structure pérovskite répondant à la formule ABO₃ dans laquelle A est choisi parmi Ba, Pb ou K, et B est choisi parmi Ti, Zr ou Ta, de préférence A est choisi parmi Ba ou Pb, et B est choisi parmi Ti ou Zr.

3. Système conducteur multicouche selon la revendication 1, dans lequel l'oxyde métallique de type pérovskite de la couche (iii) comprend un oxyde ferroélectrique (C), et :
(i) l'oxyde métallique binaire de la couche (ii) est un oxyde métallique binaire conducteur;
(ii) l'oxyde métallique binaire de la couche (ii) est un oxyde métallique binaire isolant, le substrat (i) est un substrat conducteur ; ou
(iii) l'oxyde métallique binaire de la couche (ii) est un oxyde métallique binaire isolant, le substrat (i) est un substrat isolant éventuellement transparent, et le système comprend en outre une couche (iv) supplémentaire conductrice située entre le substrat (i) et la couche (ii) d'oxyde métallique binaire ;
le système multicouche comprenant en outre une couche conductrice (cc) superposée sur la couche (iii).

4. Système conducteur multicouche selon la revendication 3, dans lequel la couche conductrice (cc) comprend un matériau conducteur, tel que :
- un oxyde métallique conducteur comme le TiO₂ ou ZnO sub-stœchiométrique en O ;
- un oxyde pérovskite conducteur ; ou
- une couche métallique conductrice, telle qu'une couche d'or, argent, ou aluminium.

5. Système conducteur multicouche selon la revendication 1 ou 2, comprenant un substrat transparent (i), une couche d'oxyde métallique binaire cristallin (ii) d'épaisseur < 20 nm, de préférence < 10 nm, tout préférentiellement 5-7 nm , et une couche (iii) comprenant un oxyde métallique conducteur transparent cristallin de type pérovskite, dans lequel
le système comprend en outre une couche transparente (ct) superposée sur la couche (iii) d'oxyde métallique conducteur, d'un oxyde métallique, de préférence conducteur, tel que TiO₂ ou ZnO sub-stœchiométrique en O, ou un oxyde isolant tel que Al₂O₃, SiO₂ et LaAlO₃, la couche (iv) recouvrant tout ou partie de la couche (iii).

6. Système conducteur multicouche selon l'une quelconque des revendications 1 à 5, dans lequel l'oxyde métallique binaire cristallin de la couche (ii) est choisi parmi au moins l'un des oxydes suivants : TiO₂, SnO₂, ZnO, Y₂O₃, ZrO₂, HfO₂ et Cr₂O₃, de préférence TiO₂.

7. Système conducteur multicouche selon la revendication 5 ou 6, dans lequel la couche (iii) d'oxyde métallique conducteur transparent a une épaisseur de 20 à 100 nm, de préférence 20 à 70 nm, plus préférentiellement 30 à 50 nm.

8. Système conducteur multicouche selon l'une quelconque des revendications 5 à 7, dans lequel l'oxyde métallique conducteur transparent de la couche (iii) répondant à la formule ABO₃ est dopé sur le site A avec Ca, La, ou autres lanthanides ; et/ou sur le site B avec Ti, Cr, Mo, ou autres métaux de transition.

9. Système conducteur multicouche selon l'une quelconque des revendications 5 à 8, dans lequel l'oxyde métallique conducteur transparent de la couche (iii) répondant à la formule ABO₃ est choisi parmi SrVO₃, SrCrO₃ et SrMoO₃ éventuellement dopés avec Ca, La, ou autres lanthanides sur le site « Sr » tels que La₁₋ₓSrₓVO₃ où x > 0.26 ou La₁₋ₓSrₓCrO₃ où x > 0.5 ; ou bien CaVO₃ éventuellement dopé sur le site « Ca » avec Sr, La, ou autres lanthanides.

10. Système conducteur multicouche selon l'une quelconque des revendications 5 à 9, dans lequel le substrat transparent (i) est en verre.

11. Système conducteur multicouche selon l'une quelconque des revendications 5 à 10, lequel a une transparence optique dans le visible > 70%, de préférence ≥ 75%.

12. Composant électronique comprenant un système conducteur multicouche d'oxydes métalliques selon l'une quelconque des revendications 1 à 11.

13. Procédé de préparation d'un système conducteur multicouche d'oxydes métalliques selon l'une quelconque des revendications 1 à 11, comprenant:
(a) le dépôt sur un substrat transparent amorphe ayant une tenue en température de 500°C, d'une couche d'un oxyde métallique binaire cristallin ;
(b) la croissance cristalline d'une couche d'un oxyde métallique conducteur cristallin sur la couche d'oxyde binaire cristallin obtenue à l'étape a), l'oxyde métallique conducteur ayant une structure cristalline de type pérovskite; et
(c) éventuellement le revêtement de la couche d'oxyde métallique conducteur obtenue en b) avec une couche protectrice (cp), éventuellement transparente, d'un oxyde métallique, de préférence conducteur, tel que TiO₂ ou ZnO sub-stœchiométrique en O, ou un oxyde isolant tel que Al₂O₄, SiO₂ et LaAlO₃, la couche obtenue en c) recouvrant tout ou partie de la couche d'oxyde métallique conducteur obtenue en b);
l'oxyde métallique binaire de l'étape a) ayant un désaccord de maille local à l'interface oxyde métallique pérovskite/oxyde métallique binaire de moins de 5% par rapport à celui de l'oxyde métallique conducteur cristallin de type pérovskite de l'étape b) ;
sous réserve que lorsque l'oxyde métallique de type pérovskite de la couche de l'étape b) est un oxyde métallique conducteur transparent cristallin, l'épaisseur de la couche d'oxyde métallique binaire cristallin de l'étape a) est < 20 nm, de préférence < 10 nm, tout préférentiellement 5-7 nm.

14. Procédé selon la revendication 13, dans lequel l'étape a) est réalisée par une technique de dépôt de couche mince, telle que la pulvérisation cathodique sous vide, l'épitaxie par jet moléculaire ou des techniques de dépôt chimique en phase vapeur comme l'Épitaxie en phase vapeur aux organométalliques ou le dépôt de couche mince atomique.

15. Procédé selon la revendication 13 ou 14, dans lequel l'étape b) est réalisée à une température ≥ 400°C, de préférence par ablation par laser pulsé, par pulvérisation cathodique sous vide, par épitaxie par jet moléculaire ou par des techniques de dépôt chimique en phase vapeur comme l'Épitaxie en phase vapeur aux organométalliques ou le dépôt de couche mince atomique, tout préférentiellement par ablation par laser pulsé ou par pulvérisation cathodique sous vide.

16. Utilisation d'un système conducteur multicouche d'oxydes métalliques selon l'une quelconque des revendications 1 à 11 :
- en optoélectronique;
- dans les technologies solaires tels que les cellules ou panneaux photovoltaïques;
- dans la technologie des capteurs, tels que les capteurs tactiles;
- dans les technologies d'affichage tels que les écrans à cristaux liquides, les écrans plats, les écrans plasma, et les écrans tactiles;
- dans les revêtements réflecteurs à infrarouge tels que le filtres/miroirs infrarouges ou les vitres/vitrages à faible émissivité;
- dans le blindage électromagnétique,
- dans l'électronique transparente;
- dans les antennes intégrées; et/ou
- dans les substrats conducteurs pour les circuits intégrés.

## Patentansprüche

1. Mehrschichtiges leitfähiges System aus Metalloxiden, umfassend:
i. ein amorphes transparentes Substrat mit einer Temperaturbeständigkeit von 500 °C;
ii. eine Schicht aus einem binären, kristallinen Metalloxid, die auf dem Substrat (i) abgelagert ist; und
iii. eine Schicht aus einem leitfähigen, kristallinen Metalloxid mit einer Perowskit-Kristallstruktur, die auf die Schicht (ii) aus binären Metalloxid aufgebracht ist;
wobei das binäre Metalloxid der Schicht (ii) an der Grenzfläche zwischen Perowskit-Metalloxid und binärem Metalloxid eine lokale Gitterfehlanpassung von weniger als 5 % im Vergleich zu der des Metalloxids der Schicht (iii) aufweist;
unter der Bedingung, dass das Perowskit-Metalloxid der Schicht (iii) ein kristallines, transparentes, leitfähiges Metalloxid ist, die Dicke der Schicht (ii) aus binären, kristallinen Metalloxid < 20 nm, vorzugsweise < 10 nm, besonders bevorzugt 5-7 nm beträgt.

2. Mehrschichtiges leitfähiges System nach Anspruch 1, wobei das Perowskit-Metalloxid der Schicht (iii) umfasst:
A. ein kristallines, transparentes, leitfähiges Metalloxid nach der Formel ABO₃, wobei A aus Sr oder Ca ausgewählt ist, das gegebenenfalls mit La oder einem anderen Element der Lanthaniden-Gruppen dotiert ist, und B aus V, Cr, Ti oder Mo ausgewählt ist;
B. ein Manganit mit kolossaler Magnetoresistivität mit Perowskit-Struktur nach der Formel Ln₍₁₋ₓ₎AₓMnO₃, wobei Ln ein Seltenerdatom (La, Pr, Nd usw.) darstellt, A aus den Erdalkalimetallatomen (Ba, Sr, Ca usw.) ausgewählt ist und x für die Dotierungsrate des Erdalkalimetalls steht; oder
C. ein ferroelektrisches Metalloxid mit Perowskit-Struktur nach der Formel ABO₃, wobei A aus Ba, Pb oder K ausgewählt ist und B aus Ti, Zr oder Ta ausgewählt ist, vorzugsweise A aus Ba oder Pb ausgewählt ist und B aus Ti oder Zr ausgewählt ist.

3. Mehrschichtiges leitfähiges System nach Anspruch 1, wobei das Perowskit-Metalloxid der Schicht (iii) ein Eisenoxid (C) umfasst, und:
(i) das binäre Metalloxid der Schicht (ii) ein leitfähiges binäres Metalloxid ist;
(ii) das binäre Metalloxid der Schicht (ii) ein isolierendes binäres Metalloxid ist, das Substrat (i) ein leitfähiges Substrat ist; oder
(iii) das binäre Metalloxid der Schicht (ii) ein isolierendes binäres Metalloxid ist, das Substrat (i) ein gegebenenfalls transparentes isolierendes Substrat ist, und das System ferner eine zusätzliche leitfähige Schicht (iv) umfasst, die sich zwischen dem Substrat (i) und der Schicht (ii) aus binärem Metalloxid befindet;
wobei das mehrschichtige System weiter eine auf die Schicht (iii) aufgebrachte leitfähige Schicht (cc) umfasst.

4. Mehrschichtiges leitfähiges System nach Anspruch 3, wobei die leitfähige Schicht (cc) ein leitfähiges Material umfasst, wie:
- ein leitfähiges Metalloxid wie TiO₂ oder ZnO, das substöchiometrisch an O ist;
- ein leitfähiges Perowskit-Oxid; oder
- eine leitfähige Metallschicht, wie eine Gold-, Silber- oder Aluminiumschicht.

5. Mehrschichtiges leitfähiges System nach Anspruch 1 oder 2, umfassend ein transparentes Substrat (i), eine Schicht (ii) aus kristallinem binärem Metalloxid mit einer Dicke von < 20 nm, vorzugsweise < 10 nm, besonders bevorzugt 5-7 nm, und eine Schicht (iii), die ein kristallines, transparentes, leitfähiges Perowskit-Metalloxid umfasst, wobei
das System weiter eine transparente Schicht (ct) umfasst, die auf die Schicht (iii) aus einem leitfähigen Metalloxid, vorzugsweise einem leitfähigen Metalloxid wie TiO₂ oder ZnO, das substöchiometrisch an O ist, oder einem isolierenden Oxid wie Al₂O₃, SiO₂ und LaAlO₃, aufgebracht ist, wobei die Schicht (iv) die die gesamte Schicht (iii) oder einen Teil davon bedecken.

6. Mehrschichtiges leitfähiges System nach einem der Ansprüche 1 bis 5, wobei das binäre kristalline Metalloxid der Schicht (ii) aus mindestens einem der folgenden Oxide ausgewählt ist: TiO₂, SnO₂, ZnO, Y₂O₃, ZrO₂, HfO₂ und Cr₂O₃, vorzugsweise TiO₂.

7. Mehrschichtiges leitfähiges System nach Anspruch 5 oder 6, wobei die Schicht (iii) transparentes leitfähiges Metalloxid eine Dicke von 20 bis 100 nm, vorzugsweise 20 bis 70 nm, bevorzugter 30 bis 50 nm, aufweist.

8. Mehrschichtiges leitfähiges System nach einem der Ansprüche 5 bis 7, wobei das transparente leitfähige Metalloxid der Schicht (iii) nach der Formel ABO₃ an der A-Stelle mit Ca, La oder anderen Lanthaniden und/oder an der B-Stelle mit Ti, Cr, Mo oder anderen Übergangsmetallen dotiert ist.

9. Mehrschichtiges leitfähiges System nach einem der Ansprüche 5 bis 8, wobei das transparente leitfähige Metalloxid der Schicht (iii) nach der Formel ABO₃ aus SrVO₃, SrCrO₃ und SrMoO₃ ausgewählt ist, die gegebenenfalls mit Ca, La oder anderen Lanthaniden an der "Sr"-Stelle dotiert ist, wie beispielsweise La₁₋ₓSrₓVO₃, wobei x > 0,26, oder La₁₋ₓSₓCrO₃, wobei x > 0,5; oder CaVO₃, das gegebenenfalls an der "Ca"-Stelle mit Sr, La oder anderen Lanthaniden dotiert ist.

10. Mehrschichtiges leitfähiges System nach einem der Ansprüche 5 bis 9, wobei das transparente Substrat (i) aus Glas ist.

11. Mehrschichtiges leitfähiges System nach einem der Ansprüche 5 bis 10, das eine optische Transparenz in dem sichtbaren Bereich von > 70 %, vorzugsweise ≥ 75 %, aufweist.

12. Elektronische Komponente, die ein mehrschichtiges leitfähiges System aus Metalloxiden nach einem der Ansprüche 1 bis 11 umfasst.

13. Verfahren zur Herstellung eines mehrschichtigen leitfähigen Systems aus Metalloxiden nach einem der Ansprüche 1 bis 11, umfassend:
(a) Auftragen einer Schicht aus einem kristallinen binären Metalloxid auf ein amorphes, transparentes Substrat mit einer Temperaturbeständigkeit von 500 °C;
(b) kristallines Aufwachsen einer Schicht aus einem kristallinen leitfähigen Metalloxid auf der in Schritt a) erhaltenen Schicht aus kristallinem binärem Oxid, wobei das leitfähige Metalloxid eine Perwoskit-Kristallstruktur aufweist; und
(c) gegebenenfalls Beschichten der in b) erhaltenen Schicht aus einem leitfähigem Metalloxid mit einer gegebenenfalls transparenten Schutzschicht (cp) aus einem Metalloxid, die vorzugsweise leitfähig ist, wie TiO₂ oder ZnO, das substöchiometrisch an O ist, oder einem isolierenden Oxid wie Al₂O₃, SiO₂ und LaAlO₃, wobei die in c) erhaltene Schicht die in b) erhaltene Schicht aus einem leitfähigen Metalloxid ganz oder teilweise bedeckt;
wobei das binäre Metalloxid aus Schritt a) an der Grenzfläche zwischen Perowskit-Metalloxid und binärem Metalloxid eine lokale Gitterfehlanpassung von weniger als 5 % im Vergleich zu der des kristallinen, leitfähigen Perowskit-Metalloxids aus Schritt b);
unter der Bedingung, dass das Perowskit-Metalloxid der Schicht aus Schritt b) ein kristallines, transparentes, leitfähiges Metalloxid ist, die Dicke der Schicht (ii) aus binären, kristallinen Metalloxid aus Schritt a) < 20 nm, vorzugsweise < 10 nm, besonders bevorzugt 5-7 nm beträgt.

14. Verfahren nach Anspruch 13, wobei Schritt a) durch eine Dünnschichtabscheidungstechnik, wie beispielsweise Vakuum-Kathodenzerstäubung, Molekularstrahlepitaxie oder chemische Gasphasenabscheidungstechniken wie metallorganische Gasphasenepitaxie oder atomare Dünnschichtabscheidung, durchgeführt wird.

15. Verfahren nach Anspruch 13 oder 14, wobei der Schritt b) bei einer Temperatur von ≥ 400 °C durchgeführt wird, vorzugsweise durch gepulste Laserablation, durch Vakuum-Kathodenzerstäubung, Molekularstrahlepitaxie oder durch chemische Gasphasenabscheidungstechniken wie metallorganische Gasphasenepitaxie oder atomare Dünnschichtabscheidung, vorzugsweise durch gepulste Laserablation oder Vakuum-Kathodenzerstäubung.

16. Verwendung eines mehrschichtigen leitfähigen Systems aus Metalloxiden nach einem der Ansprüche 1 bis 11:
- für Optoelektronik;
- in Solartechnologien wie Photovoltaikzellen oder -paneelen;
- in der Sensortechnologie, wie z. B. Berührungssensoren;
- in Anzeigetechnologien, wie z. B. Flüssigkristallbildschirmen, Flachbildschirmen, Plasmabildschirmen und Touchscreens;
- in infrarotreflektierenden Beschichtungen wie Infrarotfiltern/-spiegeln oder Scheiben/Gläsern mit geringem Emissionsvermögen;
- in der elektromagnetischen Abschirmung,
- in der transparenten Elektronik;
- in den integrierten Antennen und/oder
- in leitfähigen Substraten für integrierte Schaltkreise.

## Claims

1. Multilayer conductive system of metal oxides comprising:
i. a transparent amorphous substrate capable of withstanding a temperature of 500°C;
ii. a layer of a crystalline binary metal oxide deposited on the substrate (i); and
iii. a layer of a crystalline conductive metal oxide having a crystalline structure of perovskite type superposed over the layer of binary metal oxide (ii);
the binary metal oxide of the layer (ii) having a local lattice mismatch at the perovskite metal oxide/binary metal oxide interface of less than 5% with respect to that of the metal oxide of the layer (iii);
provided that when the metal oxide of perovskite type of the layer (iii) is a crystalline transparent conductive metal oxide, the thickness of the crystalline binary metal oxide layer (ii) is < 20 nm, preferably < 10 nm, most preferentially 5-7 nm.

2. Multilayer conductive system according to claim 1, wherein the metal oxide of perovskite type of the layer (iii) comprises:
A. a crystalline transparent conductive metal oxide having the formula ABO₃ wherein A is selected from Sr or Ca optionally doped with La or another element from the groups of lanthanides, and B is selected from V, Cr, Ti or Mo;
B. a manganite with colossal magnetoresistance of perovskite structure with the formula Ln₍₁₋ₓ₎AₓMnO₃ wherein Ln represents a rare earth atom (La, Pr, Nd, etc.), A is selected from alkaline earth atoms (Ba, Sr, Ca, etc.) and x represents the doping level of the alkaline earth, or
C. a ferroelectric metal oxide of perovskite structure with the formula ABO₃, wherein A is selected from Ba, Pb or K, and B is selected from Ti, Zr or Ta, preferably A is selected from Ba or Pb, and B is selected from Ti or Zr.

3. Multilayer conductive system according to claim 1, wherein the metal oxide of perovskite type of the layer (iii) comprises a ferroelectric oxide (C), and:
(i) the binary metal oxide of the layer (ii) is a conductive binary metal oxide;
(ii) the binary metal oxide of the layer (ii) is an insulating binary metal oxide, the substrate (i) is a conductive substrate; or
(iii) the binary metal oxide of the layer (ii) is an insulating binary metal oxide, the substrate (i) is an insulating substrate, optionally transparent, and the system further comprises an additional conductive layer (iv) located between the substrate (i) and the layer (ii) of binary metal oxide;
the multilayer system further comprising a conductive layer (cc) superposed over the layer (iii).

4. Multilayer conductive system according to claim 3, wherein the conductive layer (cc) comprises a conductive material, such as:
- a conductive metal oxide such as TiO₂ or O-substoichiometric ZnO;
- a conductive perovskite oxide; or
- a conductive metal layer, such as a layer of gold, silver, or aluminum.

5. Multilayer conductive system according to claim 1 or 2, comprising a transparent substrate (i), a crystalline binary metal oxide layer (ii) of thickness < 20 nm, preferably < 10 nm, most preferentially 5-7 nm, and a layer (iii) comprising a crystalline transparent conductive metal oxide of perovskite type, wherein
the system further comprises a transparent layer (ct) superposed over the layer (iii) of conductive metal oxide, of a metal oxide, preferably conductive, such as TiO₂ or O-substoichiometric ZnO, or an insulating oxide such as Al₂O₃, SiO₂ and LaAlO₃, the layer (iv) covering all or part of the layer (iii).

6. Multilayer conductive system according to any one of claims 1 to 5, wherein the crystalline binary metal oxide of the layer (ii) is selected from at least one of the following oxides: TiO₂, SnO₂, ZnO, Y₂O₃, ZrO₂, HfO₂ and Cr₂O₃, preferably TiO₂.

7. Multilayer conductive system according to claim 5 or 6, wherein the layer (iii) of transparent conductive metal oxide has a thickness of 20 to 100 nm, preferably 20 to 70 nm, more preferentially 30 to 50 nm.

8. Multilayer conductive system according to any one of claims 5 to 7, wherein the transparent conductive metal oxide of the layer (iii) with the formula ABO₃ is doped on the A-site with Ca, La, or other lanthanides; and/or on the B-site with Ti, Cr, Mo, or other transition metals.

9. Multilayer conductive system according to any one of claims 5 to 8, wherein the transparent conductive metal oxide of the layer (iii) with the formula ABO₃ is selected from SrVO₃, SrCrO₃ and SrMoO₃ optionally doped with Ca, La, or other lanthanides on the "Sr" site such as La₁₋ₓSrₓVO₃ where x > 0.26 or La₁₋ₓSrₓCrO₃ where x > 0.5; or even CaVO₃ optionally doped on the "Ca" site with Sr, La, or other lanthanides.

10. Multilayer conductive system according to any one of claims 5 to 9, wherein the transparent substrate (i) is in glass.

11. Multilayer conductive system according to any one of claims 5 to 10, which has an optical transparency in the visible region > 70%, preferably ≥ 75%.

12. Electronic component comprising a multilayer conductive system of metal oxides according to any one of claims 1 to 11.

13. Method for preparing a multilayer conductive system of metal oxides according to any one of claims 1 to 11, comprising:
(a) depositing on a transparent amorphous substrate capable of withstanding a temperature of 500°C, a layer of a crystalline binary metal oxide;
(b) the crystal growth of a layer of a crystalline conductive metal oxide on the crystalline binary oxide layer obtained in step a), the conductive metal oxide having a crystalline structure of perovskite type; and
(c) optionally coating the conductive metal oxide layer obtained in b) with a protective layer (cp), optionally transparent, of a metal oxide, preferably conductive, such as TiO₂ or O-substoichiometric ZnO, or an insulating oxide such as Al₂O₃, SiO₂ and LaAlO₃,
the layer obtained in c) covering all or part of the conductive metal oxide layer obtained in b);
the binary metal oxide of step a) having a local lattice mismatch at the perovskite metal oxide/binary metal oxide interface of less than 5% with respect to that of the crystalline conductive metal oxide of perovskite type of step b);
provided that when the metal oxide of perovskite type of the layer of step b) is a crystalline transparent conductive metal oxide, the thickness of the crystalline binary metal oxide layer of step a) is < 20 nm, preferably < 10 nm, most preferentially 5-7 nm.

14. Method according to claim 13, wherein step a) is carried out by a thin layer deposition technique, such as vacuum cathode sputtering, molecular beam epitaxy or chemical vapor deposition techniques such as metal-organic vapor deposition epitaxy or atomic layer deposition.

15. Method according to claim 13 or 14, wherein step b) is carried out at a temperature ≥ 400°C, preferably by pulsed laser ablation, by vacuum cathode sputtering, by molecular beam epitaxy or by chemical vapor deposition techniques such as metal-organic vapor deposition epitaxy or atomic layer deposition, most preferentially by pulsed laser ablation or by vacuum cathode sputtering.

16. Use of a multilayer conductive system of metal oxides according to any one of claims 1 to 11:
- in optoelectronics;
- in solar technologies such as solar cells or panels;
- in sensor technology, such as touch sensors;
- in display technologies such as liquid crystal screens, flat screens, plasma screens, and touch screens;
- in infrared reflective coatings such as infrared filters/mirrors or glazing/glazing units with low emissivity;
- in electromagnetic shielding,
- in transparent electronics;
- in integrated antennas; and/or
- in conductive substrates for integrated circuits.
